# EUROPEAN PATENT APPLICATION

(11) **EP 4 819 425 A1**
(43) Date of publication of application: **07.10.2026**
(21) Application number: 25167532.8
(22) Date of filing: 31.03.2025
(51) Int. Cl.: H02J 3/0014, H02J 13/00, G01R 19/25, H02J 13/12

(54) **METHOD, DEVICES AND SYSTEMS FOR DYNAMIC PHASOR ESTIMATION**

(71) Applicant: Hitachi Energy Ltd, 8050 Zürich (CH)
(72) Inventor: Bormann, Dierk, 723 53 Västerås (SE)
(74) Representative: AWA Sweden AB

(57) **Abstract**

The present disclosure relates to a computer-implemented method comprising: estimating a plurality of dynamic phasors *x̂*_{in*,k*}(*θ*) of a single- or multi-phase input signal *x*ᵢₙ(*θ*), corresponding to an electrical parameter of an electrical power system (EPS), wherein said step of estimating said plurality of dynamic phasors *x̂*_{in,*k*}(*θ*) comprises: based on information at least indicative of a highest harmonic order of non-negligible dynamic phasors of the input signal *x*ᵢₙ(*θ*), selecting a finite harmonic order *k*ₘₐₓ equal to or greater than said highest harmonic order of non-negligible dynamic phasors of the input signal *x*ᵢₙ(*θ*), providing a set of matrix representations (**x̂**, K, d, **ŷ**, G, I, **Γ**) based on said input signal *x*ᵢₙ(*θ*) and/or said finite harmonic order *k*ₘₐₓ, and computing a plurality of matrix operations applied to said set of matrix representations (**x̂**, **K, d, ŷ, G, I, Γ)** to provide a corresponding plurality of dynamic phasor estimates *x̂ₖ*(*θ*) *(k* ∈ {-*k*ₘₐₓ, ..., *k*ₘₐₓ}) to said plurality of dynamic phasors *x̂*_{in,*k*}(*θ*), wherein the plurality of matrix operations represents at least a first step of extracting signals *ŷ*ₖ(*θ*) *(k* ∈ {-*k*ₘₐₓ, ..., *k*ₘₐₓ}) from the input signal *x*ᵢₙ(*θ*) by application of a plurality of lowpass filters, and a second step of applying harmonic cancellation on the signal components *yₖ*(*θ*) = *e^{jkθ}ŷₖ*(*θ*), wherein said phase angle *θ* is controlled via a phase locked loop, PLL, which PLL receives as input at least one component of the plurality of dynamic phasor estimates *x̂*ₖ(*θ*).The present disclosure further relates to a phasor measurement unit, PMU, a monitoring system, a control device, and a power supporting system.

## Description

### Technical Field

The present disclosure relates to a method, device, and system for dynamic phasor estimation, in particular a computer-implemented method thereof, a phasor measurement unit, a monitoring system, a control device, and a power supporting system implementing the same.

### Background

Electrical power networks are vital infrastructures that facilitate the generation, transmission, and distribution of electrical energy to end users. Reliable operation of these networks hinges on a precise monitoring and analysis of key electrical parameters such as voltage, current, and frequency. These parameters are typically represented as phasors, which succinctly capture sinusoidal waveforms through their magnitude and phase angle. As such, phasor estimation is fundamental to power system analysis, underpinning critical applications like state estimation, fault detection, and power flow optimization.

Historically, phasor estimation has been conducted using algorithms designed for steady-state conditions, assuming that sinusoidal waveforms maintain constant amplitude and frequency. Common methods include Fourier transform-based techniques and zero-crossing detection. However, depending on the required phasor monitoring rate-the frequency at which phasor measurements are sampled and reported-these operations can impose significant computational demands. Moreover, modern power systems increasingly operate under dynamic and transient conditions due to factors such as integration of renewable energy sources, the prevalence of nonlinear loads, and the escalating complexity of grid interconnections. These conditions produce non-stationary waveforms, where the amplitude, frequency, and phase of sinusoidal signals fluctuate over time. Consequently, conventional phasor estimation techniques often struggle to deliver accurate and reliable results under such circumstances.

To overcome these limitations, dynamic phasor estimation methods have been developed. These approaches aim to provide real-time or near-real-time estimation of phasors under dynamic operating conditions. They utilize advanced signal processing tools-including adaptive filtering, wavelet transforms, and machine learning algorithms-to track the evolving characteristics of electrical signals. Despite these advancements, significant challenges persist in achieving high accuracy, reducing, preferably minimizing, computational complexity, and ensuring robustness against noise and measurement distortions in dynamic phasor estimation.

Given these considerations, there is a need for an improved method and system for dynamic phasor estimation.

### Summary

It is an object of the present disclosure to provide an improved solution that alleviates at least some drawbacks with present solutions. This and/or other objects, which will be implicitly and explicitly detailed in the following disclosure, are solved by one or more of the inventions defined in the claims. Advantages thereof, and additional advantageous embodiments, are described in the following.

The present disclosure is based on the inventor's realization that a computer-implemented method for phasor estimation may be enhanced by utilizing low-pass filtering in combination with a harmonic cancellation. This approach advantageously allows for more computationally efficient implementation than many conventional approaches, such as Fast-Fourier Transform (FFT) approach, which typically requires fast processing for real-time implementation to accommodate their computational complexity. Moreover, more accurate phasor estimations may be provided by the method of the present disclosure for input signals for which conventional solutions may have difficulty with due to substantial harmonic distortions.

The present disclosure therefore generally relates to the estimation of harmonic amplitudes (or 'dynamic phasors'), preferably simultaneous estimation of harmonic amplitudes, and the use of harmonic cancellation to improve the performance of frequency estimation. Moreover, the present disclosure generally relates to the estimation of harmonic amplitudes and the use of phase-locked loops (PLLs), and/or other processes which benefit from a fast, stable, and robust technique for phasor estimation, especially with noisy input signals.

According to a first aspect of the present disclosure, a computer-implemented method is provided. The method comprises:
estimating a plurality of dynamic phasors *x̂*_{in,*k*}(*θ*) of a single- or multi-phase input signal *x*ᵢₙ(*θ*), corresponding to an electrical parameter of an electrical power system (EPS), which input signal *x*ᵢₙ(*θ*) is at least a quasi-periodic signal generally having a fundamental frequency *ω*, which input signal *x*ᵢₙ(*θ*) is expressible by a Fourier series of the form ${x}_{in} \left(θ\right) = {\sum }_{k = - ∞}^{∞} {\hat{x}}_{in , k} \left(θ\right) {e}^{j kθ}$
wherein *k* is the harmonic order, $k ∈ ℤ$; *x̂*_{in,*k*}(*θ*) is the k:th dynamic phasor; e^{j*kθ*} is a basis function for the *k*:th dynamic phasor; and *θ* is a phase angle *θ* = *ωt,* wherein *t* is time,
wherein said step of estimating said plurality of dynamic phasors *x̂*_{in,*k*}(*θ*) comprises:
   based on information at least indicative of a highest harmonic order of non-negligible dynamic phasors of the input signal *x*ᵢₙ(*θ*), selecting a finite harmonic order *k*ₘₐₓ equal to or greater than said highest harmonic order of non-negligible dynamic phasors of the input signal *x*ᵢₙ(*θ*),

   providing a set of matrix representations (**x̂, K, d, ŷ, G, I, Γ**) based on said input signal *x*ᵢₙ(*θ*) and/or said finite harmonic order *k*ₘₐₓ, and
   computing a plurality of matrix operations applied to said set of matrix representations (**X̂, K, d, ŷ, G, I, Γ**) to provide a corresponding plurality of dynamic phasor estimates *x̂ₖ*(*θ*), wherein *k* ∈ {-*k*ₘₐₓ, ..., *k*ₘₐₓ}, to said plurality of dynamic phasors *x̂*_{in,*k*}(*θ*), wherein the plurality of matrix operations represents at least a first step of extracting signals *ŷₖ*(*θ*), wherein *k* ∈ {-*k*ₘₐₓ, ... , *k*ₘₐₓ}, from the input signal *x*ᵢₙ(*θ*) by application of a plurality of low-pass filters, and a second step of applying harmonic cancellation on the signal components *yₖ*(*θ*) *= e^{jkθ}ŷₖ*(*θ*),
   wherein said phase angle *θ* is controlled via a phase locked loop, PLL, which PLL receives as input at least one component of the plurality of dynamic phasor estimates *x̂ₖ*(*θ*).

It will be understood that the above method for estimating dynamic phasors in electrical power systems (EPS) offers enhanced robustness under phase-unbalanced and harmonically distorted conditions. The disclosed computer-implemented method addresses, for example, the challenge of accurately estimating dynamic phasors from single- or multi-phase input signals, which are quasi-periodic and expressible as a Fourier series with various harmonic components.

Viewing this aspect of the present disclosure from one perspective, there is provided a method for estimating a plurality of dynamic phasors of an electrical parameter in an EPS which involves selecting a finite harmonic order based on the highest non-negligible harmonic present in the input signal and using matrix operations to compute dynamic phasor estimates. The process includes two primary steps: extracting signals through low-pass filters and applying harmonic cancellation, which together enhance the accuracy of phasor estimation. This facilitates improved synchronization and control in (power) converters by providing precise dynamic phasor estimates even under distorted conditions. The method's application of matrix operations may ensure computational efficiency, while harmonic cancellation reduces, preferably minimizes, the impact of higher-order harmonics, leading to more stable and reliable phase angle estimation via the PLL.

Phasor estimation may refer to estimating a plurality of dynamic phasors, wherein each dynamic phasor corresponds to a different harmonic order of an electrical parameter. Dynamic phasor estimation may refer to estimation of harmonic amplitudes. Simultaneous estimation of harmonic amplitudes may refer to estimating harmonic amplitudes with a common plurality of operations, such as by means of the plurality of matrix operations. That is, the plurality of matrix operations need not be computed for each harmonic amplitude individually. The harmonic amplitudes may be estimated simultaneously by computing the plurality of matrix operations once.

In some embodiments, the method may comprise providing a reconstructed signal of the input signal based on the phasor estimation. The reconstructed signal may represent the fundamental and dynamic components of the input signal, capturing both magnitude and phase variations over time. By leveraging dynamic phasor estimation, the reconstructed signal can effectively filter out noise, separate harmonic components, and/or provide a clearer representation of the EPS dynamics. Additionally, this enables improved signal processing techniques for EPS stability assessments, transient analysis, and predictive maintenance. An advantage of this approach is that it allows for efficient data compression and transmission, as only the dynamic phasors need to be communicated instead of the entire raw signal. This may advantageously reduce bandwidth requirements for communication networks. Further, this may advantageously facilitate real-time control of power supporting system based on the phasor estimation by the method of the present disclosure.

The method may advantageously reduce the need to use FFT, or remove the need to use FFT entirely, in phasor estimation.

The information at least indicative of a highest harmonic order of non-negligible dynamic phasors may comprise harmonic order information such as a list of significant harmonics above a certain threshold indicating non-negligence. Harmonic order information may be extracted from the input signal via a spectral method, such as FFT. The information at least indicative of a highest harmonic order of non-negligible dynamic phasors may comprise amplitude and power information, such as amplitude of harmonics, percentages of fundamental, or harmonic power contribution. Amplitude and power information may be extracted from the input signal via a spectral method, such as FFT. The information at least indicative of a highest harmonic order of non-negligible dynamic phasors, be it harmonic order information and/or amplitude and power information, may be provided based on waveform detection of the input signal. The method may comprise detecting a waveform of the input signal, and based on the detected waveform of the input signal, comparing the detected waveform with a library of stored waveforms, each stored waveform associated with harmonic order information and/or amplitude and power information, and based on a similarity metric between the waveform of the input signal and each stored waveform, selecting a stored waveform of the library of stored waveforms as a best fit. In this way, the method may detect a waveform of the input signal and determine a highest order of non-negligible dynamic phasors. The associated information at least indicative of a highest harmonic order of non-negligible dynamic phasors may be extracted from historic data of waveforms of input signals using FFT. At least one waveform of the stored waveforms may be associated with an operating condition, such as a nominal operation or a fault. That is, the method may take into account an operating condition when assessing the similarity metric. As non-limiting examples, the similarity metric may be cross-correlation or mean squared error.

Matrix representation may refer to expression of mathematical objects, such as linear transformations, graphs, or systems of equations, using matrices. In other words, a matrix representation may be either a matrix itself or a structured way of describing a matrix. As non-limiting examples, a matrix may be represented in various structured forms, such as a 2D array (row/column storage), a flattened 1D array (stored in row-major or column-major order), a sparse matrix using formats like Compressed Sparse Row (CSR), at least one linked list where each row/column is stored as a linked list, or as an object with built-in operations for matrix algebra.

Each matrix representation (**x̂, K, d, ŷ, G, I, Γ**) may have a size wherein at least one dimension is based at least on the finite harmonic order *k*ₘₐₓ, such as a size of [2*k*ₘₐₓ + 1] x [1] or [2*k*ₘₐₓ + 1] × [2*k*ₘₐₓ + 1]. The elements of at least one matrix representation may be based at least on the input signal *x*ᵢₙ(*θ*)*.*

Computing a plurality of matrix operations applied to said set of matrix representations may refer to performing multiple operations (such as addition, multiplication, inversion, transpose, determinant, etc.) on the set of matrix representations in a structured way, such as via matrix operations.

Computer-implemented may refer to the method being implemented in a computing device. Computing device may refer to any device having computational capability, such as: a phasor measurement unit, PMU; a control device, a computer, a server, etc.

As stated, the method comprises: providing a set of matrix representations (**x̂, K**, **d, ŷ, G, I, Γ**) based on said input signal *x*ᵢₙ(*θ*) and said finite harmonic order *k*ₘₐₓ. Defining a plurality of specific matrix representations in the phasor estimation method may offer several advantages such as (but not limited to): improved computational efficiency by enabling faster processing; enhanced flexibility by adapting to varying system configurations; and/or enhanced scalability in large-scale systems. Additionally, it may improve accuracy and robustness by handling noise and disturbances more effectively, while also simplifying integration with other systems for advanced control and monitoring strategies.

According to one embodiment, said providing a set of matrix representations (**x̂**, **K, d, ŷ, G**, **I, Γ**) based on said input signal *x*ᵢₙ(*θ*) and said finite harmonic order *k*ₘₐₓ comprises:
providing a first matrix representation (**x̂**) which is a vector of length [2*k*ₘₐₓ + 1] defined as $\hat{x} : = \left(\begin{matrix}{\hat{x}}_{- {k}_{max}} \left(θ\right) \\ ⋮ \\ {\hat{x}}_{{k}_{max}} \left(θ\right)\end{matrix}\right)$
providing a second matrix representation (K) which is a square matrix of size [2*k*ₘₐₓ + 1] × [2*k*ₘₐₓ + 1] defined as $K : = \left(\begin{matrix}- {k}_{max} & & 0 \\ & ⋱ & \\ 0 & & {k}_{max}\end{matrix}\right)$
providing a third matrix representation (**d**) which is a diagonal vector of length [2*k*ₘₐₓ + 1] defined as $d : = \left(\begin{matrix}1 \\ ⋮ \\ 1\end{matrix}\right) .$

According to one embodiment, said providing a set of matrix representations (**x̂, K, d, ŷ, G**, **I, Γ**) based on said input signal *x*ᵢₙ(*θ*) and said finite harmonic order *k*ₘₐₓ comprises:
providing a fourth matrix representation (**ŷ**) which is a vector of length [2*k*ₘₐₓ + 1] defined as $\hat{y} \left(θ\right) : = \left(\begin{matrix}{\hat{y}}_{- {k}_{max}} \left(θ\right) \\ ⋮ \\ {\hat{y}}_{{k}_{max}} \left(θ\right)\end{matrix}\right)$ wherein the elements *ŷₖ* are the elements which solve the differential equation corresponding to a low-pass filtering step $\frac{d}{d θ} {\hat{y}}_{k} \left(θ\right) = {γ}_{k} \left({x}_{in}\left(θ\right){e}^{- j kθ}-{\hat{y}}_{k}\left(θ\right)\right)$ wherein the *γₖ* are predetermined, fixed relaxation rates;
providing a fifth matrix representation (**G**) which is a Hermitian matrix of size [2*k*ₘₐₓ + 1] × [2*k*ₘₐₓ + 1] defined as ${G}_{l , k} : = \frac{1}{1 + \frac{j}{{γ}_{k}} \left(k-l\right)}$ for all *k*, *l* ∈ {-kₘₐₓ, ... , *k*ₘₐₓ},
providing a sixth matrix representation (**I**) which is a unit matrix having size [2*k*ₘₐₓ + 1 ] × [2*k*ₘₐₓ + 1] $I : = \left(\begin{matrix}1 & & 0 \\ & ⋱ & \\ 0 & & 1\end{matrix}\right) ,$
and a seventh matrix representation (**Γ**) which is a diagonal matrix of size [2*k*ₘₐₓ + 1] × [2*k*ₘₐₓ + 1] with diagonal elements *γₖ* : $Γ : = \left(\begin{matrix}{γ}_{- {k}_{max}} & & 0 \\ & ⋱ & \\ 0 & & {γ}_{{k}_{max}}\end{matrix}\right) .$

According to one embodiment, said providing a set of matrix representations (**x̂, K, d, ŷ, G**, **I, Γ**) based on said input signal *x*ᵢₙ(*θ*) and said finite harmonic order *k*ₘₐₓ comprises:
providing an eight matrix representation (**x**) which is a vector of length [2*k*ₘₐₓ + 1] defined as $x \left(θ\right) = {e}^{j θ K} \hat{x} \left(θ\right)$
providing a ninth matrix representation (**y**) which is a vector of length [2*k*ₘₐₓ + 1] defined as $y \left(θ\right) = {e}^{j θ K} \hat{y} \left(θ\right) .$

The matrix representations **K, G**, **I, Γ,** and **d** may be constant and depend on 2*k*ₘₐₓ only.

The matrix representations (e.g., vectors) **x̂, ŷ, x**, and **y** may depend on the contents of the input signal.

As stated, the method comprises: computing a plurality of matrix operations applied to said set of matrix representations. Computing a plurality of matrix operations applied to the set of matrix representations may advantageously enhance accuracy and/or efficiency of phasor estimation by enabling systematic data manipulation. This approach may simplify complex calculations, reduce processing time, and allow for better handling of dynamic system conditions, ultimately improving the reliability and responsiveness of the power system. More particularly, it advantageously allows for the simultaneous estimation of the dynamic phasors.

According to one embodiment, said computing a plurality of matrix operations applied to said set of matrix representations comprises at least:
a first matrix operation corresponding to a low-pass filtering step defined as $\left(\frac{d}{d θ}+Γ-jK\right) y = Γd {x}_{in} \left(θ\right)$
a second matrix operation defined as $x \left(θ\right) = {G}^{- 1} y \left(θ\right)$
a third matrix operation defined as $\hat{x} \left(θ\right) = {e}^{- j θ K} x \left(θ\right) .$

The first matrix operation may correspond to (moderate) low-pass filtering. The second matrix operation and the third matrix operation may correspond to harmonic cancellation. Moderate low-pass filtering may refer to a gradual attenuation rather than a sharp cutoff. Moderate low-pass filtering may refer to using a cutoff frequency that retains most of the signal's useful components while reducing unwanted highfrequency noise. Moderate low-pass filtering may refer to the parameters *γₖ*, which are associated with relaxation rates, being in the order of 1. Preferably, the parameters are approximately equal to 1, however, it should be understood that other parameter values may be used. When the parameters are equal to 1, or approximately equal to 1, then a responsiveness of the method may be improved, preferably optimized, to about a response time being substantially equal to one fundamental periods or a few fundamental periods (e.g., less than 5). As a non-limiting example, the range over which attenuation occurs may be in an interval of 1-10x the cutoff frequency, in an interval of 1.25-5x the cutoff frequency, or in an interval of 1.5-3x the cutoff frequency. As non-limiting examples, the final attenuation of the low-pass filtering for highfrequency components may correspond to -12 dB/octave to -24dB/octave.

According to one embodiment, the maximum order *k*ₘₐₓ of non-negligible dynamic phasors of the input signal *x*ᵢₙ(*θ*) can for instance be determined by:
setting an amplitude threshold for the harmonic components of typical (for the targeted application) input signal, and
determining, as the non-negligible dynamic phasors, the dynamic phasors of the input signal *x*ᵢₙ(*θ*) having a magnitude exceeding the amplitude threshold.

The amplitude threshold may be set by a user or be determined based on an analysis of the electrical parameter for which a phasor estimation is to be provided. The analysis may be performed by a control device or a monitoring system based on at least one input signal corresponding to a respective electrical parameter of the EPS. As a non-limiting example, the amplitude threshold may be selected within an interval of equal to or less 10%, preferably equal to or less than 5%. It should however be understood that other amplitude thresholds may be used.

According to one embodiment, all *γₖ* are chosen to be equal, i.e., **Γ** = *γ***I** with some fixed relaxation rate *γ* > 0.

This may advantageously facilitate adjustability of the method, as only one value needs to be adjusted. Further, it may advantageously simplify implementation. However, it should be understood that different *γₖ* may be implemented. According to some embodiments, the relaxation rate is set to *γ* = 1. This may advantageously improve, preferably optimize, a settling time for phasor estimation by the method. However, it should be understood that a different value of the relaxation rate may be used.

According to one embodiment, the method is implemented to provide the plurality of dynamic phasors in continuous time domain. Implementing the method to provide the plurality of dynamic phasors in the continuous time domain may refer to that the dynamic phasors are estimated and represented as continuously varying functions over time, as opposed to discrete-time or sampled data representations. This approach may facilitate tracking the phasor estimation's changes in real-time. It may facilitate providing a continuous, smooth representation of the electrical parameter's amplitude and phase angle as they evolve over time. Providing phasors in the continuous time domain may advantageously offer higher accuracy and real-time tracking of system dynamics, thus facilitating smoother and more precise monitoring of rapidly changing electrical parameters.

According to one embodiment, the method is implemented to provide the plurality of dynamic phasors in discrete time domain. Implementing the method to provide the plurality of dynamic phasors in the discrete time domain may refer to that the dynamic phasors are estimated and represented at specific time intervals or sampling points. The continuous signal may thus be discretized, allowing operations of the method to be made based on sampled data rather than continuous time. Providing phasor estimations in the discrete time domain may advantageously promote computational efficiency, and may facilitate easier data processing, and storage efficiency, making it more practical for real-time applications and digital system implementation.

According to a second aspect of the present disclosure, a phasor measurement unit, PMU, is provided. The PMU is configured to:
receive an input signal *x*ᵢₙ(*θ*) corresponding to an electrical parameter of the electrical power system (EPS), wherein the input signal *x*ᵢₙ(*θ*) is based on measurement data from at least one sensor;
determine a plurality of dynamic phasors by the method according to any one of the preceding claims, and
determine a phasor estimation of the electrical parameter based on the plurality of dynamic phasors.

Phasor Measurement Unit (PMU) may refer to a specialized device for monitoring and measuring a dynamic behaviour of an electrical parameter in the electrical power system (EPS). The PMU may provide a precise, time-synchronized phasor estimation of the electrical parameter, such as voltage and current, in the EPS. By implementing the phasor estimation method described herein, the PMU may advantageously compute dynamic phasors with higher accuracy and/or precision than conventional methods, enabling the PMU to track fast system changes and provide detailed insight into the health and performance of the EPS in real-time or near real-time. Furthermore, time-aligned monitoring across multiple PMUs may be utilized, enhancing coordination and ensuring the robustness of the power system, while improving, preferably optimizing, operational efficiency and reducing, preferably minimizing, downtime.

The PMU may advantageously reconstruct the input signal based on the phasor estimation. This allows the PMU to output both the phasor estimation and a reconstructed signal of the input signal. The PMU may alternatively be configured to only output the reconstructed signal or the phasor estimation.

According to a third aspect of the present disclosure, a monitoring system is provided. The monitoring system comprises:
at least one phasor measurement unit, PMU, according to the second aspect or any embodiments thereof,
wherein the monitoring system is configured to:
   receive at least one input signal *x*ᵢₙ(*θ*) corresponding to a respective at least one electrical parameter of the electrical power system (EPS), each input signal *x*ᵢₙ(*θ*) being based at least on measurement data from at least one sensor, and
   determine, by the at least one phasor measurement unit (PMU), at least one phasor estimation of the respective electrical parameter corresponding to the at least one input signal *x*ᵢₙ(*θ*); and
   monitoring the at least one phasor estimation to detect whenever the at least one phasor estimation deviates from a predetermined interval.

The monitoring system may advantageously leverage at least one PMU (or a plurality of PMUs) to receive input signals corresponding to electrical parameters of an electrical power system (EPS). The monitoring system may advantageously monitor phasor estimations from these input signals to detect deviations from predefined thresholds. In other words, the monitoring system may detect real-time anomalies or system disturbances by continuously comparing actual phasor estimations against expected values. This may enable early identification of potential issues such as faults, voltage instability, or harmonic distortion, allowing for timely interventions to enhance the reliability, stability, and overall performance of the EPS. By monitoring phasor estimations in this manner, operators can improve, preferably optimize, EPS operations, prevent system failures, and improve fault detection and recovery efforts.

In some embodiments, the input signal *x*ᵢₙ(*θ*) is based at least on measurement data from at least one sensor. The at least one sensor may comprise a current transformer (CT) for measuring a current as the electrical parameter. The at least one sensor may comprise a voltage transformer (VT) for measuring a voltage as the electrical parameter. The at least one sensor may comprise a CT and a VT. The CT and VT may be used in combination.

According to a fourth aspect of the present disclosure, a control device is provided. The control device is configured to:
receive at least one phasor estimation from a respective at least one phasor measurement unit (PMU) according to the second aspect or any embodiments thereof, each phasor estimation corresponding to an electrical parameter of an electrical power system,
determine a control signal for a power converter or an energy storage system (ESS) electrically connected to the electrical power system (EPS), wherein the control signal (cs) is based at least on the at least one phasor estimation, and
provide the control signal to the power converter or the energy storage system (ESS).

The control device may advantageously process the at least one phasor estimation to determine a control signal for a power converter or energy storage system (ESS) connected to the EPS (or a power supporting system comprising the power converter and/or the ESS). This advantageously allows the control device to make real-time adjustments to the power converter or ESS based on accurate, time-synchronized measurements of the electrical system's parameters. By incorporating phasor estimations into the control strategy, the EPS may be supported dynamically to handle fluctuations in voltage, current, or power quality, improving the stability, efficiency, and performance of the EPS. This may enable better management of power flow, more precise regulation of voltage, and enhanced coordination between energy storage and power conversion processes, ultimately optimizing grid operations and ensuring smoother integration of renewable energy sources and other distributed energy resources.

According to one embodiment, the control device is configured to:
determine a power quality compensation based at least on the at least one phasor estimation, wherein the power quality compensation is representative of a current between the power converter and the electrical power system (EPS) required to suppress a harmonic distortion in the electrical power system (EPS),
wherein the control signal is further based at least on the power quality compensation.

The control device may thus advantageously control a power supporting system comprising the power converter and/or the ESS, or these directly, to support the EPS to improve, preferably optimize, power quality compensation. This may advantageously reduce power losses in the EPS.

The control device may advantageously reconstruct the input signal based on the phasor estimation. Alternatively, the control device may advantageously receive at least one reconstructed input signal from a corresponding at least one PMU.

According to a fifth aspect of the present disclosure, a power supporting system is provided. The power supporting system comprises:
at least one power converter and/or at least one energy storage system configured to electrically connect to an electrical power system via a point of common connection, PCC, and
at least one control device according to the fourth aspect or any embodiment thereof configured to control the at least one power converter and/or the at least one energy storage system.

According to one embodiment, at least one power converter of the at least one power converter is one of: a AC-to-DC converter; a DC-to-AC inverter; a DC-DC converter, and an AC-to-AC converter. The power converter may be configured to be able to operate in a first mode of operation corresponding to the above types of converters/inverters. The power converter may be configured to switch between a first mode of operation to at least a second mode of operation, wherein the first mode of operation and the at least a second mode of operation correspond to any two or more of the above types of converters/inverters.

According to one embodiment, the electrical power system (EPS) comprises at least one of: a Flexible AC Transmission System, FACTS; a Photovoltaic, PV, system; an electric vehicle, EV, system, and an electrical power network, EPN.

According to one embodiment, the EPS comprises at least one component (such as an converter, ESS, power line etc.) configured to operate at a high voltage, (HV), a medium voltage (MV), and/or a low voltage (LV).

HV typically refers to voltages that exceed those used for residential and/or commercial applications, with specific thresholds depending on the region. For example, the International Electrotechnical Commission (IEC) generally considers alternating current (AC) voltages of 1000 V or more, and direct current (DC) voltages of 1500 V or more, to be classified as high voltage. More specifically, HV may refer to electrical voltage levels equal to or greater than 35 kV and up to several hundred kilovolts. HV may however refer to electrical voltage levels equal to or greater than 115 kV.

MV typically refers to electrical voltage levels that are higher than LV, but lower than HV. MV typically includes voltages equal to or greater than 1 kV but less than 35 kV. These voltage levels are commonly used for power distribution within urban or industrial settings and for the transmission of power to transformers that supply end-user loads. MV may however refer to electrical voltage levels equal to or greater than 10 kV but less than 66 kV (and HV being equal to or greater than 66 kV).

LV typically refers to electrical voltage levels that are used for residential, commercial, and light industrial applications. LV typically includes voltages less than 1 kV, with the most common being 230 V for residential use and 400 V for commercial and industrial applications. LV power lines may be used to distribute electrical power directly to end users, such as homes, businesses, and small industries. However, LV may refer to 1000V or less (in which case MV is at least greater than 1000V but less than 35 kV or 66 kV).

It should be understood that any one power line connected between a first substation and a second substation may be any one of a HV, MV, or LV power line.

According to a sixth aspect, a computer program is provided. The computer program comprises instructions which, when the program is executed by a computing device, cause the computing device to carry out the method according to the first aspect or any embodiments thereof. The computing device may be a PMU, a control device, etc..

According to a seventh aspect, a computer-readable storage medium is provided. The computer-readable storage medium comprises instructions which, when executed by a computing device, cause the computing device to carry out the method according to the first aspect or any embodiments thereof.

Effects and features of the second and third and fourth and fifth and sixth and seventh aspects are largely analogous to those described above in connection with the first aspect. Embodiments mentioned in relation to the first aspect are largely compatible with the second and third and fourth and fifth and sixth and seventh aspects. It is further noted that the inventive concepts relate to all possible combinations of features unless explicitly stated otherwise.

The invention is defined by the appended independent claims, with embodiments being set forth in the appended dependent claims, in the following description and in the drawings. It is to be understood that this disclosure is not limited to the particular component parts of the device described or steps of the methods described as such device and method may vary. It is also to be understood that the terminology used herein is for purpose of describing particular embodiments only, and is not intended to be limiting. It must be noted that, as used in the specification and the appended claims, the articles "a", "an", "the", and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise.

### Brief Description of the Drawings

The invention will in the following be described in more detail with reference to the enclosed drawings, wherein:
Figs. 1a-1b schematically illustrate flow diagrams of the phasor estimation or aspects thereof according to some embodiments;
Figs. 2a-2b schematically illustrate flow diagrams of the phasor estimation or aspects thereof according to some embodiments;
Figs. 3a-3c schematically illustrate a phasor measurement unit, PMU, according to some embodiments;
Figs. 4a-4c schematically illustrate different embodiments of a voltage source converter;
Fig. 5 schematically illustrates an electrical power network according to some embodiments;
Fig. 6 shows graphs illustrating results obtained via simulations of a method where no harmonic cancellation is implemented;
Fig. 7 shows graphs illustrating results obtained via simulations of a method where harmonic cancellation is implemented without PLL;
Fig. 8 shows graphs illustrating results obtained via simulations of a method according to some embodiments where harmonic cancellation is implemented with PLL, and
Fig. 9 shows a flow chart of the method according to some embodiments.

### Description of Embodiments

Hereinafter, the principle of the present disclosure will be described with reference to illustrative embodiments. It should be understood that all these embodiments are given merely for the person skilled in the art to better understand and further practice the present disclosure, but not for limiting the scope of the present disclosure. For example, features illustrated or described as part of one embodiment may be used with another embodiment to yield still a further embodiment. In the interest of clarity, not all features of an actual implementation are described in this specification.

The disclosed subject matter will now be described with reference to the attached drawings. Various structures, systems and devices are schematically depicted in the drawings for purposes of explanation only and so as to not obscure the description with details that are well known to those skilled in the art. Nevertheless, the attached drawings are included to describe and explain illustrative examples of the disclosed subject matter. The words and phrases used herein should be understood and interpreted to have a meaning consistent with the understanding of those words and phrases by those skilled in the relevant art. No special definition of a term or phrase, i.e., a definition that is different from the ordinary and customary meaning as understood by those skilled in the art, is intended to be implied by consistent usage of the term or phrase herein. To the extent that a term or phrase is intended to have a special meaning, i.e., a meaning other than that understood by skilled artisans, such a special definition will be expressly set forth in the specification in a definitional manner that directly and unequivocally provides the special definition for the term or phrase.

Phasor estimation is a process which may be used to analyse time-varying signals, particularly in the context of electrical engineering and signal processing. A phasor may be a complex entity representing the amplitude and phase of a periodic signal such as a sinusoidal signal. By estimating the phasor, characteristics of the signal such as frequency, phase, and magnitude can be efficiently described. This approach is particularly valuable for analysing signals in the frequency domain and is commonly used in power systems, communication systems, and signal processing applications.

An input signal *x*ᵢₙ(*t*) that is repetitive (more precisely, quasi-periodic) with some constant fundamental frequency *ω*, can be expressed by a generalized discrete Fourier series of the form ${x}_{in} \left(t\right) = {\sum }_{k = - ∞}^{∞} {\hat{x}}_{in , k} \left(t\right) {e}^{j kωt}$ (1) with slowly varying complex harmonic amplitudes *x̂*_{in,*k*}(*t*)*,* $k ∈ ℤ$. Complex harmonic amplitudes may refer to dynamic phasors of harmonic order *k*.

"Slowly varying" may refer to that the spectra of *x̂*_{in,*k*} only contain frequencies significantly lower than *ω*, i.e., the Fourier transforms of *x̂*_{in,*k*} are nonnegligible only for frequencies that are significantly smaller than *ω* (e.g., at least 5x smaller).

In other words, that the *x̂*_{in,*k*}(*t*) changes very little during one fundamental signal period, which has a length $T = \frac{2 π}{ω}$

Further, the symbol "^" (like in *x̂*_{in,*k*}) for dynamic phasors is used to distinguish them from the corresponding "physical" quantities (in this case, *x*ᵢₙ) that typically oscillate with frequency *ω.* In a stationary state (i.e., when *x*ᵢₙ(*t*) is strictly periodic with frequency *ω*) all *x̂*_{in,*k*} may be constants.

As the dynamic phasors *x̂*_{in,*k*}(*t*) are slowly varying, they can be approximately expressed as Fourier integrals over a moving single-period time window [*t-T* , *t*] of constant length *T*: ${\hat{x}}_{in , k} \left(t\right) \approx \frac{1}{T} {\int }_{t - T}^{t} d t ′ {x}_{in} \left(t′\right) {e}^{- j kωt ′}$ (2)

Examples for signals *x*ᵢₙ(*t*) may comprise single-phase current or voltage signals, which are real functions of time, and/or space phasors associated to a 3-phase current or voltage *x_{abc}*(*t*), which are complex functions.

For real functions *x*ᵢₙ(*t*), the corresponding phasors obey the relations ${\hat{x}}_{in , - k} \left(t\right) = {\hat{x}}_{in , k}^{∗} \left(t\right)$ for all $k ∈ ℤ$. For complex functions *x*ᵢₙ(*t*), however, there are no such constraints for the corresponding phasors *x̂*_{in,*k*}(*t*), so they are independent functions for all $k ∈ ℤ$**.**

The space phasor associated to a 3-phase signal *x_{abc}*(*t*) may be defined as follows. First, the components of the real function *x_{abc}*(*t*) for the respective phases (phase a, b, c) are transformed onto the *αβ*0 frame by the unitary (i.e., power-invariant) version of the Clarke transformation *T*_{C}: ${x}_{αβ 0} \left(t\right) : = {T}_{C} {x}_{abc} \left(t\right)$ (3a) with ${T}_{C} : = \frac{1}{\sqrt{6}} \left(\begin{matrix}2 & - 1 & - 1 \\ 0 & \sqrt{3} & - \sqrt{3} \\ \sqrt{2} & \sqrt{2} & \sqrt{2}\end{matrix}\right)$ (3b)

For a general, unbalanced 3-phase signal *x_{abc}*(*t*), the new components *x_{α}*(*t*), *x_{β}*(*t*), and *x*₀(*t*) are independent quasi-periodic functions of time. Second, the space phasor associated to *x_{abc}*(*t*) may be described (apart from a normalizing factor) as the complex function *x*ᵢₙ(*t*) that has *x_{α}*(*t*) and *x_{β}*(*t*) as its real and imaginary parts: ${x}_{in} \left(t\right) : = \frac{1}{\sqrt{2}} \left[{x}_{α}\left(t\right)+j {x}_{β}\left(t\right)\right] = \frac{1}{\sqrt{3}} \left[{x}_{a}\left(t\right)+ε {x}_{b}\left(t\right)+ε*{x}_{c}\left(t\right)\right] ,$ (4) with the complex 3^{rd} root of unity $ε : = {e}^{j 2 π / 3} = \frac{- 1 + j \sqrt{3}}{2} \left({ε}^{2}={ε}^{- 1}={ε}^{∗}\right)$. Note that (4) is just the first component of the complex 3-vector *x*₊₋₀ of symmetric components, which may be expressed as: ${x}_{+ - 0} \left(t\right) : = S {x}_{abc} \left(t\right)$ (5a) with $S : = \frac{1}{\sqrt{3}} \left(\begin{matrix}1 & ε & {ε}^{∗} \\ 1 & {ε}^{∗} & ε \\ 1 & 1 & 1\end{matrix}\right)$ (5b)

The transformation matrix *S* on symmetric components (5b) is unitary, too.

With the above equation (4), the complex dynamic phasors *x̂*_{in,*k*}(*t*) are independent functions for all $k ∈ ℤ$. For instance, the *k =* 1 term of equation (1) corresponds in this case to the positive-sequence fundamental component of the 3-phase signal *x_{abc}*(*t*) and the *k =* -1 term to the negative-sequence fundamental component. The zero-sequence component *x*₀(*t*) can separately be represented in the form (1) for a real signal (unless it is a priori known to be zero, e.g., due to the circuit topology).

A common method for estimating time dependent dynamic phasor values from a digitized measured signal *x*ᵢₙ(*t*) is to simply compute equation (2) numerically in every time step by FFT on a moving time window. Assuming that *ω* is constant, all time-dependent quantities may be expressed as functions of the fundamental phase angle *θ* := *ωt* (instead of *t*)*.* Equations (1), (2) can thus be expressed as follows: ${x}_{in} \left(θ\right) = {\sum }_{k = - ∞}^{∞} {\hat{x}}_{in , k} \left(θ\right) {e}^{j kθ}$ (1') ${\hat{x}}_{k} \left(θ\right) {e}^{j kθ} \approx \frac{1}{2 π} {\int }_{- 2 π}^{0} d θ ′ {x}_{in} \left(θ+θ′\right) {e}^{- j kθ ′} = : {x}_{k} \left(θ\right)$ (2')

After determining *x̂ₖ*(*θ*) by FFT, the input waveform *x*ᵢₙ(*θ*) can be approximately reconstructed by suitable truncation of the original Fourier series (1), for instance, up to some finite order *k*ₘₐₓ: ${x}_{rec} \left(θ\right) \approx {\sum }_{k = - {k}_{max}}^{{k}_{max}} {\hat{x}}_{k} \left(θ\right) {e}^{j kθ} = {\sum }_{k = - {k}_{max}}^{{k}_{max}} {x}_{k} \left(θ\right) .$ (6)

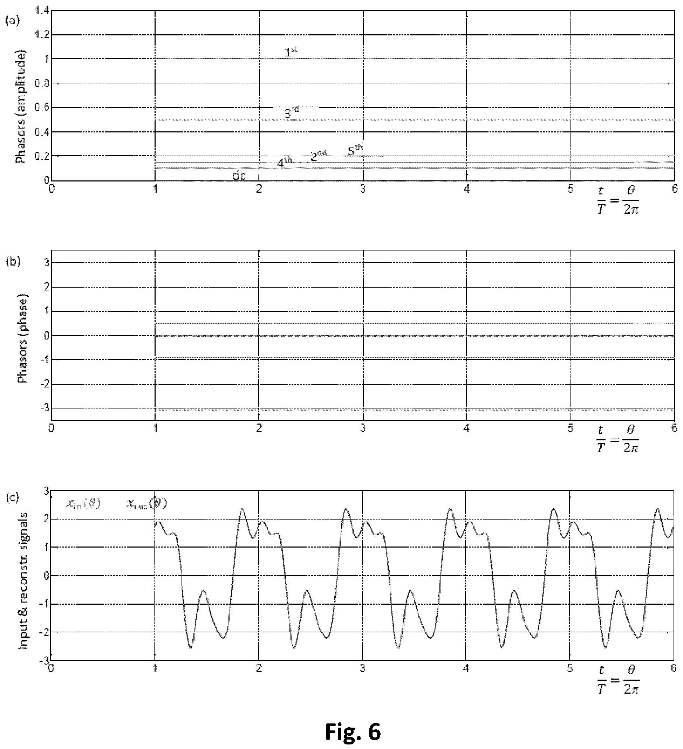

Numerical results based on (2'), (6) are shown in Fig. 6, in which a stationary input signal *x*ᵢₙ(*t*) is simulated, and Fig. 6a shows estimated phasor amplitudes |*x̂ₖ*| for *k =* 0, ..., 5; Fig. 6b shows estimated phasor phase angles arg(*x̂ₖ*) for *k =* 0, ... , 5, and Fig. 6c illustrates a comparison between input signal *x*ᵢₙ(*t*) (red) and reconstructed *x*_{rec}(*t*) (blue).

However, conventional methods such as FFT may be seen as computationally expensive, at least in relation to the method of the present disclosure, and thus more computationally expensive to implement for real-time application with sufficiently high resolution, i.e., so that the selected finite order *k*ₘₐₓ indeed is equal to (or higher than) the highest order of non-negligible harmonics. If the selected finite order *k*ₘₐₓ is less than the highest order of non-negligible harmonics, then the phasor estimation may become too inaccurate. It is therefore of interest to implement the method of the present disclosure which implements at least harmonic cancellation.

If the fundamental angular frequency *ω* is constant, then all time-dependent quantities may be expressed as functions of the fundamental phase angle *θ* :*= ωt.* Further, the input signal *x*ᵢₙ(*t*) may consist of a finite number of nonnegligible harmonics, so that, like for *x*_{rec} in (6), the infinite sum (1') can be limited to -*k*ₘₐₓ ≤ *k* ≤ *k*ₘₐₓ , where *k*ₘₐₓ is the largest order.

According to (1'), *x̂*_{*in*,*k*}(*θ*) is the slowly varying part of e^{-j}*^{kθ}x*ᵢₙ(*θ*), so in principle, *x̂*_{in,*k*}(*θ*) can be extracted from the latter with a very-narrow-band low-pass filter that suppresses all contributions with harmonic order ≠*k*. However, such a process would result in quite slow responses to any changes of *x̂*_{in,*k*}(*θ*) while fail to completely suppress the remaining ripple.

Instead, coupled equations of motion may be considered for the dynamic phasors *x̂ₖ* that converge to the exact (constant) phasors *x̂*_{in,*k*} for any stationary input signal *x*ᵢₙ(*θ*)*.* Matrix representations, such as compact matrix notation, may be introduced, defining the following (2*k*ₘₐₓ +1)-dimensional vectors: $\hat{x} : = \left(\begin{matrix}{\hat{x}}_{- {k}_{max}} \\ ⋮ \\ {\hat{x}}_{{k}_{max}}\end{matrix}\right) , d : = \left(\begin{matrix}1 \\ ⋮ \\ 1\end{matrix}\right) \left("diagonal"\right) ,$ (7a,b) and the square matrix $K : = \left(\begin{matrix}- {k}_{max} & & 0 \\ & ⋱ & \\ 0 & & {k}_{max}\end{matrix}\right) .$ (7c)

For instance, (1') can now be re-written in matrix notation as follows, thus constituting at least one example of a matrix operation: ${x}_{in} \left(θ\right) = {d}^{T} {e}^{j θ K} {\hat{x}}_{in} \left(θ\right) .$ (8)

For equations of motion in continuous time, the following may be considered. In a first step, "rough approximations" *ŷₗ*(*θ*) to *x̂*_{in,*l*}(*θ*) may be extracted for all *l*, applying only (moderate) low pass filtering on e^{-j}*^{lθ}x*ᵢₙ(*θ*)*.* In a second step, the remaining highfrequency ripple may be removed by harmonic cancellation, exploiting the fact that all *x̂*_{*in*,*l*}(*θ*) are derived from the same signal *x*ᵢₙ(*θ*), and thus are related. To simplify the notation, the argument *θ* on all time-dependent quantities like *x*ᵢₙ, *x̂*_{in,*k*}, *ŷₖ*, etc., may be suppressed/omitted unless it is needed to avoid ambiguities.

From expansion (1), it immediately follows that for any given integer *l*, ${e}^{- j lθ} {x}_{in} = {\sum }_{k = - ∞}^{∞} {\hat{x}}_{in , k} {e}^{j \left(k-l\right) θ}$ (9)

The low-pass filtering may be described using auxiliary dynamic variables ${\hat{y}}_{in , l} : = {\sum }_{k = - ∞}^{∞} \frac{{\hat{x}}_{in , k} {e}^{j \left(k-l\right) θ}}{1 + \frac{j}{{γ}_{l}} \left(k-l\right)}$ (10) with *γₗ* > 0 being dimensionless constants associated with respective relaxation rates. Note that the phasors *x̂*_{in,*k*} are slowly varying by assumption, whereas the *ŷ*_{in,*k*} defined by (10) are not slowly varying; namely, as will be illustrated below, they have nonnegligible harmonic components with harmonic frequencies (*k - l*)*ω*. Neglecting the time derivatives of the *x̂*_{in,*k*}, approximate differential equations for *ŷ*_{in,*l*} can be formulated that become exact in the limit of *x̂*_{in,*k*} being constant in time: $\frac{d {\hat{y}}_{in , l}}{d θ} \approx {\sum }_{k = - ∞}^{∞} {\hat{x}}_{in , k} \frac{j \left(k-l\right) {e}^{j \left(k-l\right) θ}}{1 + \frac{j}{{γ}_{l}} \left(k-l\right)} = {γ}_{l} \left({x}_{in} {e}^{- j lθ}-{\hat{y}}_{in , l}\right)$ (11a)

Using (11a), new functions *ŷₗ* by the differential equations (11a) may be defined, i.e., as solutions of $\frac{d}{d θ} {\hat{y}}_{l} = {γ}_{l} \left({x}_{in} {e}^{- j lθ}-{\hat{y}}_{l}\right) ,$ (11b) so that the *ŷₗ* are expected to be sufficiently good approximations to the *ŷ*_{in,*l*}, given that the *x̂*_{in,*k*} are slowly varying. Furthermore, sufficiently good approximations *x̂ₖ* to the original *x̂*_{in,*k*} can then be obtained from the solutions *ŷₗ* to (11b) by inverting the relation (10) between *x̂*_{in,*k*} and *ŷ*_{in,*l*} and substituting *ŷₗ* for *ŷ*_{in,*l*}.

According to (11b), *ŷₗ* relaxes towards e^{-j}*^{lθ}x*ᵢₙ with a rate *γₗω*, or in other words, *ŷₗ* is obtained from e^{-j}*^{lθ}x*ᵢₙ by applying a 1^{st} order low-pass filter with cutoff frequency *γₗω* (and thus with gain $\frac{{γ}_{l} ω}{{γ}_{l} ω + s}$, where s is the Laplace variable). Thus, *ŷₗ* vary on a typical time scale equal to the inverse cutoff frequency $\frac{1}{{γ}_{l} ω}$.

To extract the phasors *x̂ₖ* from the *ŷₗ* , equation (10) can be expressed in the form ${\hat{y}}_{l} {e}^{j lθ} = {\sum }_{k = - ∞}^{∞} {G}_{l , k} {\hat{x}}_{k} {e}^{j kθ}$ (12) where *G_{l,k}* are the entries of an infinite Hermitian matrix, defined by ${G}_{l , k} : = \frac{1}{1 + \frac{j}{{γ}_{l}} \left(k-l\right)} , for all k , l ∈ ℤ$ (13)

In practice, harmonics of high enough order in the input signal are negligibly small, so the sums in equations (1)-(12) can be limited to some finite range -*k*ₘₐₓ ≤ *k*, *l* ≤ *k*ₘₐₓ. To obtain reliable results, *k*ₘₐₓ must be chosen at least equal to the highest non-negligible order of harmonics contained in the input signal *x*ᵢₙ(*t*) (note, however, that it may safely be chosen higher than strictly necessary, e.g., by +10% or more of *k*ₘₐₓ; this does not change the results). So, (2*k*ₘₐₓ + 1)-dimensional vectors may be defined as $\hat{x} : = \left(\begin{matrix}{\hat{x}}_{- {k}_{max}} \\ ⋮ \\ {\hat{x}}_{{k}_{max}}\end{matrix}\right) \hat{y} : = \left(\begin{matrix}{\hat{y}}_{- {k}_{max}} \\ ⋮ \\ {\hat{y}}_{{k}_{max}}\end{matrix}\right) d : = \left(\begin{matrix}1 \\ ⋮ \\ 1\end{matrix}\right) \left("diagonal"\right)$ (14a-c) as well as square matrices $G : = {\left(\frac{1}{1 + \frac{j}{{γ}_{l}} \left(k-l\right)}\right)}_{- {k}_{max} \leq l , k \leq {k}_{max}} and K : = \left(\begin{matrix}- {k}_{max} & & 0 \\ & ⋱ & \\ 0 & & {k}_{max}\end{matrix}\right)$ (15a,b)

This allows for equations (11b) and (12) to be expressed in matrix form: $\left(\frac{d}{d θ}+Γ\right) \hat{y} = {e}^{- j θ K} Γd {x}_{in} ,$ (16a) with the diagonal matrix $Γ : = \left(\begin{matrix}{γ}_{- {k}_{max}} & & 0 \\ & ⋱ & \\ 0 & & {γ}_{{k}_{max}}\end{matrix}\right) ,$ (16c) and ${e}^{j θ K} \hat{y} = G {e}^{j θ K} \hat{x} .$ (16c)

For any *γₗ* > 0, the square matrix **G** defined in (15a) is non-singular and thus invertible, and so **x̂**(*θ*) can be obtained from **ŷ**(*θ*) by multiplying (16c) with e^{-j*θ*K}**G**⁻¹. Note that **G** is a constant matrix (given that *γₗ* are chosen constant), so the inversion may advantageously be performed only once and the result for **G**⁻¹ stored in memory for further use. This advantageously enhances computational efficiency.

Note the *θ*-dependent matrix exponential e^{-j*θ***K**} in (16a, 16b) may be removed by defining quantities $x : = {e}^{j θ K} \hat{x} , y : = {e}^{j θ K} \hat{y} ,$ (17a,b) or equivalently, in components, ${x}_{k} : = {\hat{x}}_{k} {e}^{j kθ} and {y}_{k} : = {\hat{y}}_{k} {e}^{j kθ} , for - {k}_{max} \leq k , l \leq {k}_{max} .$ (18a,b)

With (17), equation (16) can be expressed as $\left(\frac{d}{d θ}+Γ-jK\right) y = Γd {x}_{in} ,$ (19a) $y = G x .$ (19b)

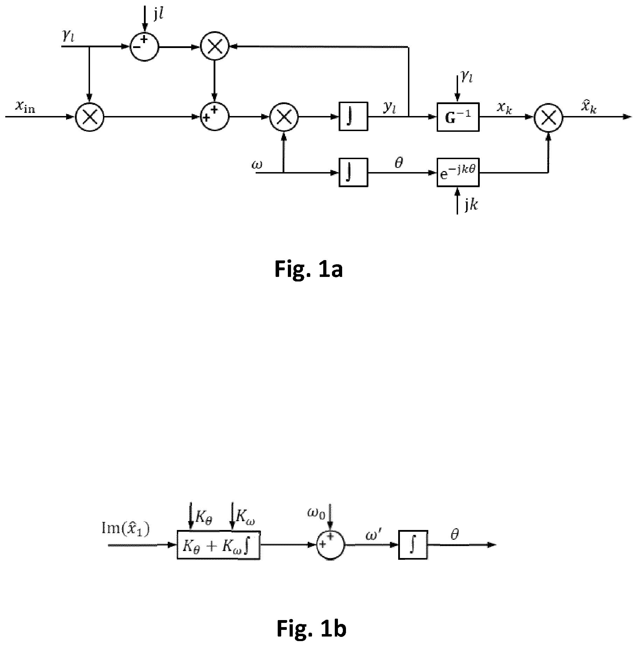

According to (17a), the estimated phasor vector **x̂** is then given by $\hat{x} \left(θ\right) = {e}^{- j θ K} x \left(θ\right) = {e}^{- j θ K} {G}^{- 1} y \left(θ\right) ,$ (20) where **y**(*θ*) is a solution of (19a). The phasor estimation procedure, defined by equations (19) and (20), can be visualized by the flow diagram shown in Fig. 1a. Moreover, reconstruction *x*_{rec} of the original signal *x*ᵢₙ from the estimated phasors *x̂ₖ* (or, alternatively, from the *xₖ*) may be given by equation (6).

For computer-implementation of the method, for instance in a control device or a phasor measurement unit (PMU), the differential equation (19a) is converted into a difference equation, in discrete time domain, with constant discrete step length Δ*θ* = ωΔ*t.* Following common practice, Tustin's approximation (also known as bilinear transformation) can be used in this mapping, which corresponds to the trapezoidal rule for integration and is substantially more stable than the simple Euler method. Alternatively, Runge-Kutta methods may be utilized.

Tustin's approximation generally comprises two steps: 1. identifying the functional dependence of the continuous-time differential equations (11b), (16a), or (19a) on the Laplace variable s (corresponding to $\frac{d}{d t} = ω \frac{d}{d θ}$), and 2. replacing it by $\frac{2}{Δ t} \frac{z - 1}{z + 1}$ (or, equivalently, replacing $\frac{d}{d θ}$ in the equations by $\frac{2}{Δ θ} \frac{z - 1}{z + 1}$), which yields the *z-*transform of a discrete-time approximation. Applied to (19a), this procedure leads to the following equation: $\frac{2}{Δ θ} \frac{z - 1}{z + 1} y = - \left(Γ-jK\right) y + Γd {x}_{in}$ (21a) $⇔ \left(z-1\right) y = \frac{Δ θ}{2} \left(z+1\right) \left[-\left(Γ-jK\right) y+Γd {x}_{in}\right]$ (21b) or, equivalently, $z {C}_{+} y = C _ y + \frac{Δ θ}{2} \left(z+1\right) Γd {x}_{in}$ (22a) with constant matrices ${C}_{\pm } : = \left[I\pm \frac{Δ θ}{2}\left(Γ-jK\right)\right]$ (22b)

(Here **I** denotes the (2*k*ₘₐₓ + 1)-dimensional unit matrix.)

By inverse z-transformation of (22a), the corresponding difference equation for **y** can be obtained, which together with the discrete version of (20) may form a complete set of equations for determining the estimated phasor vector **x̂***ᵢ* at discrete instances of time *tᵢ* (or phase angle *θᵢ*): ${y}_{i + 1} = {C}_{+}^{- 1} \left[{C}_{-}{y}_{i}+\frac{Δ θ}{2}Γd\left({x}_{in , i + 1}+{x}_{in , i}\right)\right]$ (23a) and ${\hat{x}}_{i} = {e}^{- j {θ}_{i} K} {x}_{i} = {e}^{- j {θ}_{i} K} {G}^{- 1} {y}_{i}$ (23b) where ${θ}_{i} : = {θ}_{0} + i Δ θ$ (23c)

As **C₊** (defined in (22b)) is a constant matrix, its inverse ${C}_{+}^{- 1}$ again only needs to be calculated once, thus allowing it to be stored in memory for enhanced computational efficiency. To obtain unique solutions from (23), initial conditions may be selected; in practice, usually the trivial choice **y**_{*i*=0} = **0** (for which also **ŷ**₀ = **x**₀ = **x̂**₀ = **0**) is satisfactory.

For formulation directly in terms of phase vector (in continuous time), the above equations (19a,b) can be combined with (20) to obtain a differential equation directly for the phasor vector **x̂.** This formulation may be favorable in certain contexts, like small-signal stability analysis, as will be shown below. To derive it, an equation for**x** obtained by inserting (19b) into (19a) may be considered: $\frac{d}{d θ} x = Ax + {G}^{- 1} Γd {x}_{in} ,$ (24) with a constant dynamic matrix **A** of the following form: $A = {G}^{- 1} \left(jK-Γ\right) G .$ (25)

The intermediate matrix factor (j**K** - **Γ**) in (25) is a diagonal matrix, whose elements therefore are the eigenvalues of **A**, and the corresponding eigenvectors are the columns of **G⁻¹.** Thus, all eigenvalues of -**A** have positive real parts (which are equal to the *γₗ*), implying absolute stability of (24) for arbitrary input signal *x*ᵢₙ and initial conditions x(0). Small deviations δ**x** = **x** - **x_{∗}** from a stationary state **x_{∗}** (i.e., one in which **x̂_{∗}** = e^{-j*θ*}**^{K} x_{∗}** is constant) may obey the homogeneous version of (24): $\frac{d}{d θ} δx = A δx .$ (26)

As (26) is linear and time-independent (LTI), it can potentially be used as part of the small-signal model of a larger system (like, for instance, a DC-AC converter) that contains the above phasor estimation procedure as part of its control, while it still remains LTI, so that the stability of the larger system can be assessed by eigenvalue analysis of its system matrix.

With (25), the solution of (26) can be written as follows: $δx \left(θ\right) = {e}^{A θ} δx \left(0\right) = {G}^{- 1} {e}^{\left(jK-Γ\right) θ} G δx \left(0\right) .$ (27a)

In the special case **Γ** = *γ***I** where *γ* has the same value for all harmonics, this becomes $δx \left(θ\right) = {e}^{- γθ} {G}^{- 1} {e}^{jK θ} G δx \left(0\right) ,$ (27b) where the overall scalar pre-factor e^{-*γθ*} (in front of a bounded expression) again ensures stability. A differential equation for **x̂** is obtained from (24) by substituting **x** = e^{j*θ*K} **x̂** (see (20)) and multiplying the whole equation with e^{-j*θ***K**} from the left: $\frac{d}{d θ} \hat{x} = \left(-jK+{e}^{- j θ K}A {e}^{j θ K}\right) \hat{x} + {e}^{- j θ K} {G}^{- 1} Γd {x}_{in} .$ (28)

Note that, in contrast to equation (26) for δ**x**, the homogeneous part of equation (28), governing small deviations δ**x̂** from **x̂_{★},** is not LTI, while its stability of course is ensured by the stability of (26).

Exploiting the specific form of the matrix **G** that appears in the definition (25) of **A,** equation (28) can be further simplified. From the definition (13) or (15a) of the matrix entries of **G,** it follows that $j \left(k-l\right) {G}_{l , k} = {γ}_{l} \left(1-{G}_{l , k}\right)$ (29a) for any pair of indices (*k, l*), which can be re-stated in matrix notation as: $j \left(GK-KG\right) = Γ \left({dd}^{T}-G\right)$ (29b)

Note that **G** is uniquely determined by (29a) (or, equivalently, (29b)), i.e., there is one and only one solution for **G.** Substitution of (29b) into (25) yields: $A = jK - {G}^{- 1} {Γdd}^{T} ,$ (30) so that (28) can be re-written in the following form, where the expression between parentheses is a scalar quantity that vanishes in a stationary state: $\frac{d}{d θ} \hat{x} = {e}^{- j θ K} {G}^{- 1} Γd \left({x}_{in}-{d}^{T}{e}^{j θ K}\hat{x}\right) .$ (31)

In the special case **Γ** = *γ***I**, any deviation δ**x̂** = **x̂** - **x̂**ᵢₙ from a stationary **x̂**ᵢₙ may decay exponentially with the same asymptotic rate, which is due to the overall factor e^{-*γθ*} in (27b). In particular, for the evolution during any time interval with the length of one fundamental period, (27b) yields $δ \hat{x} \left(θ+2π\right) = {e}^{- γ 2 π} δ \hat{x} \left(θ\right) for any θ$ (32) i.e., all harmonic components in the deviation δ**x̂** have been reduced by the same factor e^{-*γ*2*π*} after one fundamental period. With the parameter choice *γ* = 1, this factor is actually quite small (e^{-2*π*} < 0.002), thus resulting in that transient fluctuations may cease almost completely in a short amount of time, such as during one fundamental period after a sudden change in the spectral content of the input signal *x*ᵢₙ.

Although the stationary equation for δ**x̂** (i.e., the homogeneous part of (28) or (31)) is not strictly Linear Time-Invariant, LTI, (32) suggests that it can, as part of the small-signal model of a larger system, be replaced "on average" (on time scales longer than the fundamental period) by a simple relaxation $\frac{d}{d θ} δ \hat{x} = - γ δ \hat{x}$. The dynamics of a larger system may then become LTI again "on average", and long-time stability thereof can approximately be assessed by simple eigenvalue analysis.

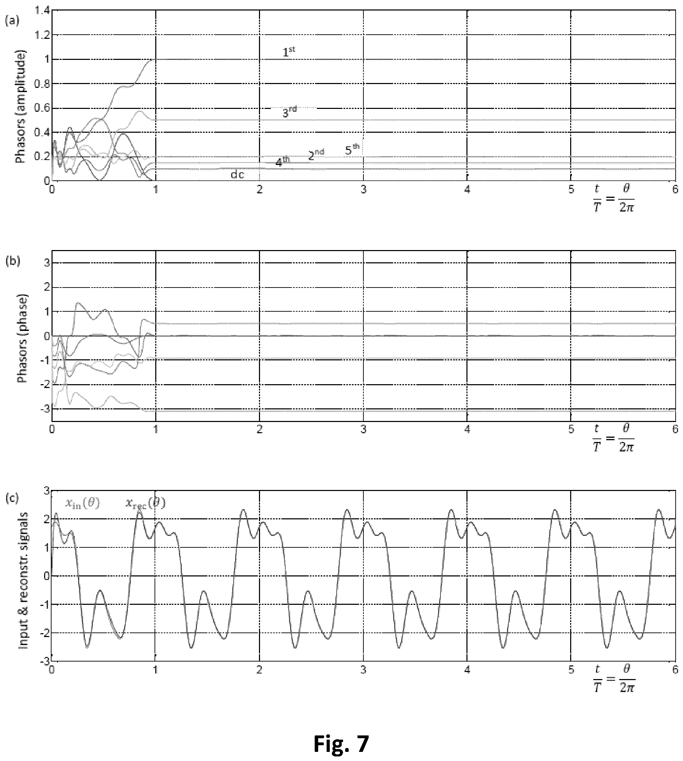

Numerical results based on equations (51b-e) (see below) with a given, fixed fundamental frequency ω, are shown in Fig. 7, in which a stationary input signal *x*ᵢₙ(*t*) is simulated, and Fig. 7a shows estimated phasor amplitudes |*x̂ₖ*| for *k* = 0, ..., 5; Fig. 7b shows estimated phasor phase angles arg(*x̂ₖ*) for *k* = 0, ..., 5, and Fig. 7c illustrates a comparison between input signal *x*ᵢₙ(*t*) (red) and reconstructed *x*_{rec}(*t*) (blue).

The above method for dynamic phasor estimation using FFT performs satisfactory for ideal situations, i.e., a fundamental frequency of the input signal *x*ᵢₙ does not vary. However, for most real-life scenarios, the frequency of the input signal *x*ᵢₙ will vary, sometimes substantially, relative the fundamental frequency. Thus, the above method for dynamic phasor implementing harmonic cancellation may be further enhanced to combine the harmonic cancellation with a PLL for tracking a varying input frequency *ω*(*t*)*.* For continuous time domain, this may be achieved by replacing the previous relation *θ* = *ωt* (with known, constant *ω*) by differential equations for *ω* and *θ* such that $\frac{d θ}{d t} = ω = const$ in any stationary state.

Furthermore, it may be desired that *θ* in any stationary state is equal to the phase angle of the fundamental component *x*₁(*θ*) *= x̂*₁ e^{j*θ*} of *x*ᵢₙ(*θ*), so that the fundamental phasor *x̂*₁ becomes a purely real constant. This may be achieved by complementing (15), (19), (20) with the following equations for *θ* and *ω*: $\frac{d θ}{d t} = ω + {K}_{θ} Im \left({\hat{x}}_{1}\right) \left[=:ω′\right] ,$ (33a) $\frac{d ω}{d t} = {K}_{ω} Im \left({\hat{x}}_{1}\right) ,$ (33b) where ${K}_{θ} = {{K}^{˜}}_{θ} \frac{{ω}_{0}}{{\hat{x}}_{1 , 0}}$ and ${K}_{ω} = {{K}^{˜}}_{ω} \frac{{ω}_{0}^{2}}{{\hat{x}}_{1 , 0}}$, with *ω*₀ and *x̂*_{1,0} denoting fixed reference values of fundamental frequency and (real) amplitude, values from which *x*ᵢₙ(*t*) does not deviate substatially. *K̃_{θ}*, *K̃_{ω}* > 0 are dimensionless constants, independent of *ω*₀ and *x̂*_{1,0}. Note that according to (33a), $\frac{d θ}{d t}$ is different from *ω* as long as the "error" *K_{θ}* Im(*x̂*₁) is nonzero, while $\frac{d θ}{d t} = ω$ as intended in any stationary state where Im(*x̂*₁) = 0. It is worth nothing that (33a,b) can trivially be combined into a single matrix equation: $\frac{d}{d t} \left(\begin{matrix}θ \\ ω\end{matrix}\right) = \left(\begin{matrix}0 & 1 \\ 0 & 0\end{matrix}\right) \left(\begin{matrix}θ \\ ω\end{matrix}\right) + \left(\begin{matrix}{K}_{θ} \\ {K}_{ω}\end{matrix}\right) Im \left({\hat{x}}_{1}\right) .$ (34)

Integrating (33b) and inserting the result into (33a), the following is obtained: $\frac{d θ}{d t} = {ω}_{0} + {K}_{ω} {\int }_{0}^{t} Im \left({\hat{x}}_{1}\right) + {K}_{θ} Im \left({x}_{1}\right) ,$ (35) which defines a PI controller for $\frac{d θ}{d t}$ that suppresses the "error" Im(*x̂*₁). The estimation procedure for *x̂*₁ contained in (15), (19), (20) together with the PI controller (33a,b) or (35) forms an estimation process for the phase angle *θ*. A flow diagram of this estimation process is shown in Fig. 1b.

Performing a variable change from the phase angle *θ* to time t in (19a) and then inserting (33a), yields the following equation: $\frac{dy}{d t} = \frac{d θ}{d t} \frac{dy}{d θ} = ω ′ \left[\left(-Γ+jK\right)y+Γd{x}_{in}\right] ,$ (36a) where *x̂*₁ is obtained from **y** as the *k* = 1 component of the phasor vector (20), **x̂** = e^{-j*θ*}**^{K} G**⁻¹**y**, with the fixed matrices **G, K** defined in (15a,b).

Alternatively, the analogous variable change may be applied to (24) or (31): $\frac{dx}{d t} = \frac{d θ}{d t} \frac{dx}{d θ} = ω ′ \left(Ax+b{x}_{in}\right) ,$ (36b) or $\frac{d \hat{x}}{d t} = \frac{d θ}{d t} \frac{d \hat{x}}{d θ} = ω ′ {e}^{- j θ K} b \left({x}_{in}-{d}^{T}{e}^{j θ K}\hat{x}\right) ,$ (36c) with a constant vector $b : = {G}^{- 1} Γd .$ (36d)

The fundamental phasor *x̂*₁ in the definition (33a) of *ω*' is then obtained from **x** or **y** by invoking (20). The three equations (36a-c), describing the dynamics of either the phasor variable **x̂** or one of the auxiliary variables **y** or **x,** may be equivalent to one another.

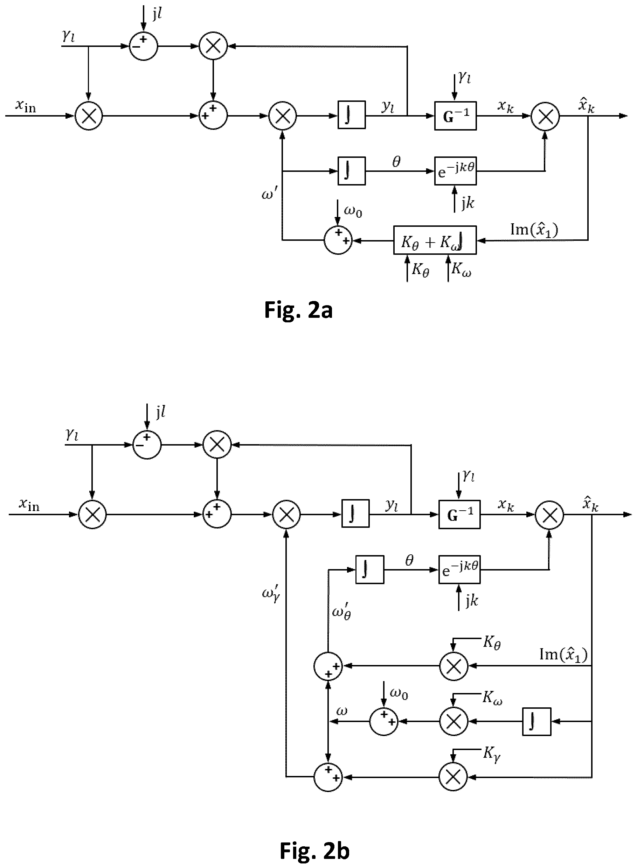

To increase the flexibility for optimizing the control, it is possible to set *ω*' = *ω* + *K_{γ}* Im(*x̂*₁) in (36a-c), considering *K_{γ}* as a distinct parameter whose value may differ from that of *K_{θ}* in (33a). The parameter may be referred to as *K_{γ}* because the factor *ω*' in effectively modulates the relaxation rates *γₖ* (which in (36b,c) are contained in **A** and **b**). Flow diagrams of the complete phasor estimation procedure including PLL, defined by equations (33a,b) and (36a), are shown in Figs. 2a-2b, for both the special case *K_{γ} = K_{θ}* (Fig. 2a) and the general case *K_{γ} ≠ K_{θ}* (Fig. 2b).

To distinguish the two cases, the following notation may be used $\begin{matrix}{ω}_{θ}^{′} : = ω + {K}_{θ} Im \left({\hat{x}}_{1}\right) , \\ {ω}_{γ}^{′} : = ω + {K}_{γ} Im \left({\hat{x}}_{1}\right) .\end{matrix}$ (37a,b)

Naturally, if *K_{γ} = K_{θ}* then ${ω}_{γ}^{′} = {ω}_{θ}^{′}$ at all times. Moreover, ${ω}_{γ}^{′} = {ω}_{θ}^{′} = ω =$ const. in any stationary state, even if *K_{γ} ≠ K_{θ}*, since then Im(*x̂*₁) = 0. Numerical simulation of the above equation system shows that in order to avoid instabilities, *K_{γ}* typically needs to be chosen smaller than *K_{θ}* (in fact, the observation of instabilities was the original motivation for treating it as a separate parameter). In the stable regime though, the dynamics turns out to be rather insensitive to the precise value of *K_{γ}*, and satisfactory results are obtained in most cases by simply setting *K_{γ} =* 0.

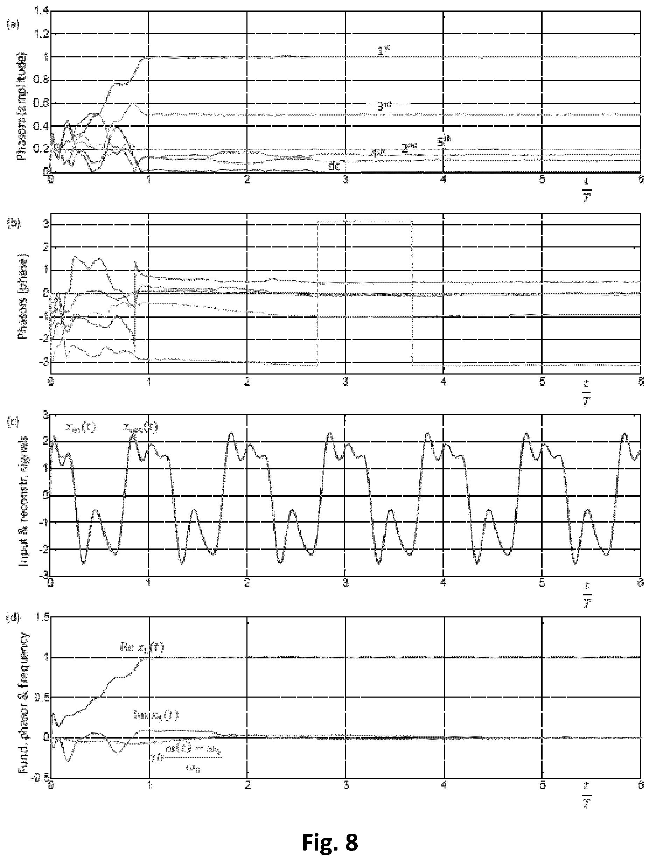

Numerical results based on equations (51b-e) (see below) with fundamental frequency ω determined by the PLL are shown in Fig. 8, in which a stationary input signal *x*ᵢₙ(*t*) is simulated, and Fig. 8a shows estimated phasor amplitudes |*x̂ₖ*| for *k =* 0, ... , 5; Fig. 8b shows estimated phasor phase angles arg(*x̂ₖ*) for *k* = 0, ..., 5, and Fig. 8c illustrates a comparison between input signal *x*ᵢₙ(*t*) (red) and reconstructed *x*_{rec}(*t*) (blue).

A linear stability analysis may be performed of the coupled equation system formed by (33a,b) or (34), describing the PLL, together with (36c). Small deviations *δθ*, *δω*, δ**x̂** from a stationary solution may be assumed, and periodic *x*ᵢₙ. That is, *x*ᵢₙ is assumed to be characterized by a constant fundamental frequency *ω*_{∗} and a corresponding phase angle of the form *θ*_{∗}(*t*) = *ω_{∗}t* + *θ*₀, and by constant phasors **x̂**_{∗}. From (34) and (36c), linear order in the deviations may be obtained: $\frac{d}{d t} δ θ = δ ω + {K}_{θ} Im \left(δ{\hat{x}}_{1}\right) ,$ (38a) $\frac{d}{d t} δ ω = {K}_{ω} Im \left(δ{\hat{x}}_{1}\right) ,$ (38b) $\frac{d}{d t} δ \hat{x} = - {ω}_{∗} {e}^{- j {θ}_{∗} K} {bd}^{T} {e}^{j {θ}_{∗} K} \left(jK{\hat{x}}_{∗}δθ+δ\hat{x}\right) ,$ (38c) where in (38c) it has been used that, in the stationary state, *x*ᵢₙ - **d**^{T}ₑ^{j*θ*_{∗}K} **x̂**_{∗} *=* 0, and Im(*x̂*_{∗,1}) = 0 (due to the PLL). Note that the linearized equation system (38a-c) does not depend on *K_{γ}* anymore, which may be consistent with the numerical observation of its insensitivity to the choice of *K_{γ}.*

Next, the equations (38a-c) may be combined into a single matrix equation. For notational convenience, the *θ*-dependent matrix may be defined $B \left(θ\right) : = {e}^{- j θ K} {bd}^{T} {e}^{j θ K}$ (39) and the imaginary part in (38a,b) may be expressed as a product of linear operators "Im" and " ${e}_{1}^{T}$", acting on δ**x̂**, so that $Im \left(δ{\hat{x}}_{1}\right) = Im {e}_{1}^{T} δ \hat{x}$**.** The following is thus obtained $\frac{d}{d t} \left(\begin{matrix}δ θ \\ δ ω \\ δ \hat{x}\end{matrix}\right) = \left(\begin{matrix}0 & 1 & {K}_{θ} Im {e}_{1}^{T} \\ 0 & 0 & {K}_{ω} Im {e}_{1}^{T} \\ - {ω}_{∗} B \left({θ}_{∗}\right) jK {\hat{x}}_{∗} & 0 & {ω}_{∗} B \left({θ}_{∗}\right)\end{matrix}\right) \left(\begin{matrix}δ θ \\ δ ω \\ δ \hat{x}\end{matrix}\right) .$ (40)

Due to the dependence of **B**(*θ*_{∗}) on *θ*_{∗} = *ω_{∗}t* + *θ*₀, this system is not LTI, but only LTP (linear time-periodic), and so a systematic analysis of its stability could presumably be done using Floquet theory. As an option, a simple, approximate argument may be used, based on the observation that the dynamics described by (40) leads to an equal damping of all harmonic components in δ**x̂** within one fundamental period, with a common factor e^{-2*πγ*} that is independent of the harmonic order. This may be formalized as follows
*Proposition:* The state transition matrix **Φ**(*θ*, *θ*') for the phasor components only (i.e., referring to **x̂** but not to *θ* and *ω*) is given by $Φ \left(θ,θ′\right) = {e}^{- γ \left(θ-θ′\right)} {e}^{- j θ K} {G}^{- 1} {e}^{j \left(θ-θ′\right) K} G {e}^{j θ K} .$ (41)
*Corollary:* If *θ* - *θ*' is an integer multiple of 2*π*, then the exponential in (41) becomes equal to **I,** so that for any *θ* simply $Φ \left(θ+2π,θ\right) = {e}^{- 2 πγ} I ,$ (42) i.e., **Φ**(*θ* + 2*π,θ*) is proportion to the unit matrix **I,** and all its eigenvalues are equal to e^{-2*πγ*}.
*Proof of* (41): The state transition matrix **Φ**(*θ*, *θ'*) for the phasor components is defined as the solution of the differential equation $\frac{d}{d θ} Φ \left(θ,θ′\right) = - B \left(θ\right) Φ \left(θ,θ′\right)$ with initial condition **Φ**(*θ'*, *θ'*) **= I.** Due to (29b), it can yield **-bd**^{T} + j**K** = -*γ***I** + j**G⁻¹K G** = **G⁻¹**(**-***γ***I** + j**K**) **G**, and so yielding definition (39): $\frac{d}{d θ} \left[{e}^{j θ K}Φ\left(θ,θ′\right)\right] = {e}^{j θ K} \left[jK-B\left(θ\right)\right] Φ \left(θ,θ′\right) = {G}^{- 1} \left(jK-γI\right) G {e}^{j θ K} Φ \left(θ,θ′\right) .$ (43)
Straightforward integration of (43) yields ${e}^{j θ K} Φ \left(θ,θ′\right) = {G}^{- 1} {e}^{\left(θ-θ′\right) \left(jK-γI\right)} G {e}^{j θ K} = {e}^{- γ \left(θ-θ′\right)} {G}^{- 1} {e}^{j \left(θ-θ′\right) K} G {e}^{j θ K} .$ (44)
Finally, (41) is obtained by multiplying (44) with e^{-j*θ***K**} from the left. □

Backed by (42) and by the observation that the dynamics of δ*θ* and δ*ω*, as defined by (38)-(40), is slower than that of δ**x̂** it is proposed that for an approximate stability analysis of (40), **B**(*θ*_{∗}) may be replaced by the constant matrix *γ***I**. The resulting, simplified linearized equation system reads $\frac{d}{d t} \left(\begin{matrix}δ θ \\ δ ω \\ δ \hat{x}\end{matrix}\right) = \left(\begin{matrix}0 & 1 & {K}_{θ} Im {e}_{1}^{T} \\ 0 & 0 & {K}_{ω} Im {e}_{1}^{T} \\ - {ω}_{∗} γ jK {\hat{x}}_{∗} & 0 & - {ω}_{∗} γ I\end{matrix}\right) \left(\begin{matrix}δ θ \\ δ ω \\ δ \hat{x}\end{matrix}\right) ,$ (45) which now is LTI and thus allows simple eigenvalue analysis of the dynamic matrix.

The simplest case is when the stationary state is a 3-phase balanced pure sine wave, containing no negative- or zero-sequence components and no harmonics, i.e., *x̂_{k,∗}* = *x̂*_{1,*∗*}δ_{1*k*}. In this case, (45) can be further simplified by noting that all components δ*x̂ₖ* with *k ≠* 1 decouple from the rest and individually obey the simple equation $\frac{d}{d t} δ {\hat{x}}_{k} = - {ω}_{∗} γ δ {\hat{x}}_{k}$, with negative eigenvalue *-ω_{∗}γ.*

Furthermore, separating the fundamental positive-sequence component into real and imaginary parts, $δ {\hat{x}}_{1} = δ {\hat{x}}_{1}^{′} + jδ {\hat{x}}_{1}^{"}$, and recalling that ${\hat{x}}_{1 , ∗}^{"} = 0$, it can be seen that $δ {\hat{x}}_{1}^{′}$ also decouples with the individual eigenvalue *-ω_{∗}γ.* The only remaining phasor component that couples to δ*θ* and δ*ω* is $δ {\hat{x}}_{1}^{"} = Im \left(δ{\hat{x}}_{1}\right)$, and the resulting, reduced equation system is $\frac{d}{d t} \left(\begin{matrix}δ θ \\ δ ω \\ δ {\hat{x}}_{1}^{"}\end{matrix}\right) = \left(\begin{matrix}0 & 1 & {K}_{θ} \\ 0 & 0 & {K}_{ω} \\ - {ω}_{∗} γ {\hat{x}}_{1 , ∗} & 0 & - {ω}_{∗} γ\end{matrix}\right) \left(\begin{matrix}δ θ \\ δ ω \\ δ {\hat{x}}_{1}^{"}\end{matrix}\right) ,$ (46a)

Equivalently, this may be expressed in terms of p.u. variables, defined as $\frac{1}{{ω}_{*} γ} \frac{d}{d t} \left(\begin{matrix}δ θ \\ δ {ω}^{˜} \\ δ {x}^{˜}\end{matrix}\right) = \left(\begin{matrix}0 & 1 / γ & {{K}^{˜}}_{θ} \\ 0 & 0 & γ {{K}^{˜}}_{ω} \\ - 1 & 0 & - 1\end{matrix}\right) \left(\begin{matrix}δ θ \\ δ {ω}^{˜} \\ δ {x}^{˜}\end{matrix}\right) .$ (46b) wherein δ*ω̃* := δ*ω*/*ω_{∗}*, $δ {x}^{˜} : = δ {\hat{x}}_{1}^{"} / {\hat{x}}_{1 , ∗} , {{K}^{˜}}_{θ} : = \frac{{K}_{θ} {\hat{x}}_{1 , ∗}}{{ω}_{∗} γ}$, and ${{K}^{˜}}_{ω} : = \frac{{K}_{ω} {\hat{x}}_{1 , ∗}}{{\left({ω}_{∗}γ\right)}^{2}}$.

It is also possible to define ${{K}^{˜}}_{γ} : = \frac{{K}_{γ} {\hat{x}}_{1 , ∗}}{{ω}_{∗} γ}$.

The eigenvalues of the dynamic matrix in (46b) are the zeros of its characteristic polynomial, which is given by $\begin{matrix}χ \left(λ\right) & = det \left(\begin{matrix}λ & - 1 / γ & - {{K}^{˜}}_{θ} \\ 0 & λ & - γ {{K}^{˜}}_{ω} \\ 1 & 0 & λ + 1\end{matrix}\right) = {λ}^{2} \left(λ+1\right) + λ {{K}^{˜}}_{θ} + {{K}^{˜}}_{ω} \\ & = {λ}^{2} \left(λ+1\right) + {{K}^{˜}}_{θ} \left(λ+q\right) ,\end{matrix}$ (47) were the quotient *q* :*= K̃_{ω}*/*K̃_{θ}* has been introduced. Note that expression (47) does not explicitly depend on *γ* anymore (only through the definitions of *K̃_{θ}* and *K̃_{ω}*).

For any *K̃_{θ}* > 0, *χ*(*λ*) always has one negative real zero *λ* < 0 (*λ* → -1 for *K̃_{θ}* → 0 and/or *q* → 1) as well as a pair of complex conjugate zeros. The real part of the complex zeros is negative for 0 < *q* < 1, positive for *q >* 1, and zero for *q =* 1 (where $λ = \pm j \sqrt{{{K}^{˜}}_{θ}}$). In the limit of large *K̃_{θ}*, the three zeros are located at *λ* ≈ *-q* and $\frac{q - 1}{2} \pm$ $j \sqrt{{{K}^{˜}}_{θ}}$. For any given *K̃_{θ}* > 0, the equation system (46b) (or, equivalently, (46a)) is thus stable if 0 < *q* < 1 (so that the real parts of all three eigenvalues are negative), unstable if *q >* 1, and marginally stable in the limits *q* → 0 or *q* → 1 (where the real part of at least one of the eigenvalues approaches zero).

The above, simplified stability argument suggests that a reasonable parameter choice may be $q \approx \frac{1}{3}$ (so that none of the eigenvalue real parts is smaller than $\frac{1}{3}$), while the choice of *K̃_{θ}* does not seem to affect the stability. Numerically, it has been observed (by trial and error) that a good compromise between stability and fast response usually is obtained with combinations of parameter values that satisfy the following conditions: $\begin{matrix}0.7 ≲ γ ≲ 1.5 \\ 10 ≲ {{K}^{˜}}_{θ} ≲ 50 \\ q = {{K}^{˜}}_{ω} / {{K}^{˜}}_{θ} \approx 0.15 \\ {{K}^{˜}}_{γ} / {{K}^{˜}}_{θ} ≲ 0.2\end{matrix}$ (48a-d) In practice, *K̃_{γ}* may be set as *K̃_{γ}* = 0 since choosing a nonzero value does not appear to improve the performance.

For discrete time implementation, equations (34) and (36a) may be translated. In analogy to (21), (22), the following is obtained: $\left(z-1\right) \left(\begin{matrix}θ \\ ω\end{matrix}\right) = \frac{Δ t}{2} \left(z+1\right) \left[\left(\begin{matrix}0 & 1 \\ 0 & 0\end{matrix}\right)\left(\begin{matrix}θ \\ ω\end{matrix}\right)+\left(\begin{matrix}{K}_{θ} \\ {K}_{ω}\end{matrix}\right)Im\left({\hat{x}}_{1}\right)\right]$ (49a) $\left(z-1\right) y = \frac{Δ t}{2} \left(z+1\right) \left[ω+{K}_{γ} Im\left({\hat{x}}_{1}\right)\right] \left[-\left(γI-jK\right) y+{γx}_{in}d\right]$ (49b) or, equivalently, $z {D}_{+} \left(\begin{matrix}θ \\ ω\end{matrix}\right) = {D}_{-} \left(\begin{matrix}θ \\ ω\end{matrix}\right) + Δ t \left(\begin{matrix}{K}_{θ} \\ {K}_{ω}\end{matrix}\right) Im \left({\hat{x}}_{1}\right)$ (50a) $z {C}_{+} y = {C}_{-} y + \frac{Δ t}{2} \left(z+1\right) \left[ω+{K}_{γ} Im\left({\hat{x}}_{1}\right)\right] {γx}_{in} d$ (50b) with matrices ${D}_{\pm } : = \left(\begin{matrix}1 & ∓ Δ t / 2 \\ 0 & 1\end{matrix}\right)$ (50c) ${C}_{\pm } : = I \pm \frac{Δ t}{2} \left[ω+{K}_{γ} Im\left({\hat{x}}_{1}\right)\right] \left(γI-jK\right)$ (50d)

By inverse z-transformation of (50a,b), the corresponding difference equations may be obtained for *θ*, *ω,* and **y**, which together with the discrete version of (20) form a complete set of equations for determining the estimated phasor vector **x̂***ᵢ* = **x̂**(*tᵢ*) at discrete instances of time, *tᵢ = i* Δ*t.*

Note that all occurrences of Im(*x̂*_{1,*i*+1}) in these equations has been replaced by Im(*x̂*_{1,*i*}), since *x̂*_{1,*i*+1} is known only after the time step has been performed (this amounts to treating *x̂*₁ as a constant in the z-transform and updating it after each time step, which may be justified by the assumption that *x̂*₁(*t*) is slowly varying): $\left(\begin{matrix}{θ}_{i + 1} \\ {ω}_{i + 1}\end{matrix}\right) = {D}_{+}^{- 1} \left[{D}_{-}\left(\begin{matrix}{θ}_{i} \\ {ω}_{i}\end{matrix}\right)+Δt\left(\begin{matrix}{K}_{θ} \\ {K}_{ω}\end{matrix}\right)Im\left({\hat{x}}_{1 , i}\right)\right]$ (51a) ${y}_{i + 1} = {C}_{+ , i}^{- 1} \left[{C}_{- , i}{y}_{i}+\frac{Δ t}{2}γd\left(\left[{ω}_{i + 1}+{K}_{γ} Im\left({\hat{x}}_{1 , i}\right)\right]{x}_{in , i + 1}+\left[{ω}_{i}+{K}_{γ} Im\left({\hat{x}}_{1 , i}\right)\right]{x}_{in , i}\right)\right]$ (51b) with ${C}_{+ , i} : = I + \frac{Δ t}{2} \left(γI-jK\right) \left[{ω}_{i + 1}+{K}_{γ} Im\left({\hat{x}}_{1 , i}\right)\right]$ (51c) ${C}_{- , i} : = I - \frac{Δ t}{2} \left(γI-jK\right) \left[{ω}_{i}+{K}_{γ} Im\left({\hat{x}}_{1 , i}\right)\right]$ (51d) and ${\hat{x}}_{i} = {e}^{- j {θ}_{i} K} {x}_{i} = {e}^{- j {θ}_{i} K} {G}^{- 1} {y}_{i}$ (51e)

Equations (51b-d) can be simplified by replacing *ω*_{*i*+1} with *ωᵢ*, which is again justified by the assumption that *ω*(*t*) is slowly varying and, in fact, does not lead to any perceptible change of behaviour in numerical simulations: ${y}_{i + 1} = {C}_{+ , i}^{- 1} \left[{C}_{- , i}{y}_{i}+\frac{Δ t}{2}γd\left[{ω}_{i}+{K}_{γ} Im\left({\hat{x}}_{1 , i}\right)\right]\left({x}_{in , i + 1}+{x}_{in , i}\right)\right]$ (51b') with ${C}_{\pm , i} : = I \pm \frac{Δ t}{2} \left(γI-jK\right) \left[{ω}_{i}+{K}_{γ} Im\left({\hat{x}}_{1 , i}\right)\right]$ (51c')

As an alternative for formulation with dynamic variable x (slower algorithm), (36b) may be translated instead of (36a) into discrete time and, like above, replacing *ω*_{*i*+1} + *K_{γ}* Im(*x̂*_{1,*i*+1}) with *ωᵢ + K_{γ}* Im(*x̂*_{1,*i*}), resulting in that instead of (51a-e) the following is obtained: $\left(\begin{matrix}{θ}_{i + 1} \\ {ω}_{i + 1}\end{matrix}\right) = {D}_{+}^{- 1} \left[{D}_{-}\left(\begin{matrix}{θ}_{i} \\ {ω}_{i}\end{matrix}\right)+Δt\left(\begin{matrix}{K}_{θ} \\ {K}_{ω}\end{matrix}\right) Im\left({\hat{x}}_{1 , i}\right)\right]$ (52a) ${x}_{i + 1} = {{C}^{˜}}_{+ , i}^{- 1} \left[{{C}^{˜}}_{- , i}{x}_{i}+\frac{Δ t}{2}b \left[{ω}_{i}+{K}_{γ} Im\left({\hat{x}}_{1 , i}\right)\right]\left({x}_{in , i + 1}+{x}_{in , i}\right)\right]$ (52b) with ${{C}^{˜}}_{\pm , i} : = I ∓ \frac{Δ t}{2} A \left[{ω}_{i}+{K}_{γ} Im\left({\hat{x}}_{1 , i}\right)\right] ,$ (52c) and ${\hat{x}}_{i} = {e}^{- j {θ}_{i} K} {x}_{i} .$ (52d)

As an option, parameter *K_{γ}* may be set to *K_{γ} =* 0 , leading to further simplification of (51b',c') and (52b,c).

Note that the **C**_{±,*i*} in (51b',c') are diagonal matrices, in contrast to the **C̃**_{±,*i*} in (52b,c), so the earlier formulation (51b',c') with **y** as auxiliary dynamic variable will usually require less computational effort than (52b,c), especially when the maximum harmonic order *k*ₘₐₓ is large.

The various discrete procedures for dynamic phasor estimation were applied to a single-phase real input signal *x*_{in,*i*} :*= x*ᵢₙ(*i*Δ*θ*) with $Δ θ = \frac{2 π}{{N}_{θ}}$, where *N_{θ}* is the number of discrete time steps within a fundamental period $T = \frac{2 π}{ω}$. In the example, the input signal contains both even and odd harmonics up to 5^{th} order. The initial complex amplitudes (phasors) of the harmonics were chosen as follows ${\hat{x}}_{1} = 1.0 , {\hat{x}}_{2} = 0.15 {e}^{0.5 j} , {\hat{x}}_{3} = 0.5 {e}^{3.4 j} , {\hat{x}}_{4} = 0.1 , and {\hat{x}}_{5} = 0.2 {e}^{- 0.9 j} .$ (53)

Results of the simulations are represented in Figs. 6-8, wherein Fig. 6 illustrates results using FFT for the phasor estimation, while Fig. 7 and Fig. 8 illustrate results using the harmonic cancellation method without and with PLL implemented, respectively. In all numerical examples, parameter value *N_{θ}* was set to *N_{θ}* = 400, corresponding to 20 kHz sampling frequency for 50 Hz fundamental frequency (which may be a typical value in practical applications).

Fig. 6 illustrates the estimation of phasors using FFT within a moving window for a given, fixed grid frequency *ω*, i.e., without a PLL. The convergence time after a sudden change of amplitude or phase of the input signal *x*ᵢₙ(*t*) is approximately equal to the length of the moving window, i.e., exactly one fundamental period T.

The harmonic cancellation approach is based on first-order differential (or difference) equations in time [like (55a,b), (16a,b), (19a,b), (23a-c), (31), (63), (36a-c), etc., so an initial condition is needed. In the simulation, **y**_{*i*=0} is "arbitrarily" set to as **y**_{*i*=0} = **0** as the initial state. Fig. 7 clearly shows that initially, or after a sudden change of amplitude or phase of the input signal *x*ᵢₙ(*t*), relaxation into a stationary state typically takes a time of about one fundamental period T, which is the same short convergence time as for phasor estimation using FFT within a moving window (Fig. 6).

However, the method of the present disclosure may be computationally less expensive than FFT approach for phasor estimation.

A computational cost of the FFT approach (specifically radix-2 FFT) may typically be in the order of *~*(*N* log₂ *N*) in each time step, wherein N is the number of samples in the sliding window. As the number of samples N is proportional to the ratio of the sampling frequency *fₛ* to the fundamental frequency *f*₀, the computational cost of the FFT approach in each time step may equivalently be described as $\frac{{f}_{s}}{{f}_{0}} {log}_{2} \frac{{f}_{s}}{{f}_{0}} .$*_{.}*

According to (51b-e), the method of the present disclosure involves, in each time step, operations with square matrices of dimension (2*k*ₘₐₓ + 1) on vectors, so the computational cost is proportional to ∼(2*k*ₘₐₓ + 1)² in each time step, independently of sampling rate. So, for a large sampling rate (i.e., a large ratio $\frac{{f}_{s}}{{f}_{0}}$), the method of the present disclosure can be considerably less expensive.

For example, for the case of a sampling ratio of 20 kHz, a fundamental frequency of 50 Hz, and a finite harmonic order *k*ₘₐₓ equal to 15 (which may be a typical value of concern in electrical power systems), then the computational cost of the FFT approach is approximately 3 600 operations per time step, whereas the computational cost of the present disclosure implementing harmonic cancellation and PLL is 961 operations per time step, which is indeed significantly cheaper than the FFT approach.

A plurality of different values of the dimensionless relaxation rate *γ* were tested to see which values yield the best performance. Simulations indicate that the parameter value *γ* = 1.0 is close to optimal: substantially larger values lead to even wilder fluctuations during transients, while substantially smaller values lead to longer settling times than one fundamental period *T*.

In this context, the following observation was made. Even during transient phases, the reconstructed signal *x*_{rec}(*t*) always appears to remain relatively close to the input signal *x*ᵢₙ(*t*), although the estimated phasors typically fluctuate substantially, for one or even several periods.

These latter fluctuations are related to the fundamental fact that harmonic amplitudes and phases during a period of transients are inherently ill-defined, or in other words, the decomposition of a repetitive but non-periodic signal as in equation (1), whose Fourier amplitudes are time-dependent, is not unique. As a consequence, it may be impossible in principle to achieve settling times that are reliably shorter than *T*, be it by adjusting *γ* or by any other means. Thus, choosing *γ* = 1.0, or in other words, choosing the cutoff frequency *γω* of the low-pass filter equal to the fundamental frequency *ω* of the input signal *x*ᵢₙ(*t*), may be close to optimal.

The most challenging case for the FFT approach is a sudden small change of the input signal frequency. If the changed frequency is maintained, it leads to a slow drift of the phase angles of the individual phasors, and also to some fluctuations of their amplitudes; in particular, the DC property of the stationary-state phasors is lost.

A considerably more stable operation for temporally varying frequency of the input signal is achieved by introducing a PLL-type feedback mechanism of the form shown in Fig. 2, adjusting the reference frequency *ω* of the estimation algorithm and locking it to the fundamental, positive-sequence component of the input signal. Simulation results including this feedback mechanism is shown in Fig. 8. The PLL parameter values in these examples were chosen as follows: ${K}_{θ} / {f}_{0} = 1.6 , {K}_{ω} / {f}_{0}^{2} = 0.85 , and {K}_{γ} / {f}_{0} = 1.1 .$ (54)

The PLL may compensate for a sudden change (e.g., 10%) of the input signal frequency within a rather short settling time (for the above example, the settling time was about 4*T* = four fundamental periods).

The new method for dynamic phasor estimation of the present disclosure, based on a combination of moderate low-pass filtering and harmonic cancellation, is advantageously very robust and stable. The new algorithm converges reliably within one fundamental period, as the error in all harmonic components may be reduced during that time by a factor ≈ e^{-2*π*} < 0.002, independently of the initial conditions chosen. As a consequence, the method of the present disclosure may advantageously perform sufficiently accurate phasor estimation despite sudden amplitude changes and/or sudden phase shifts of the fundamental or any harmonic component present. By implementing PLL, it may advantageously hinder, preferably prevent, the phasor vector **x̂** from beginning to 'drift', with magnitudes oscillating back and forth among different harmonics.

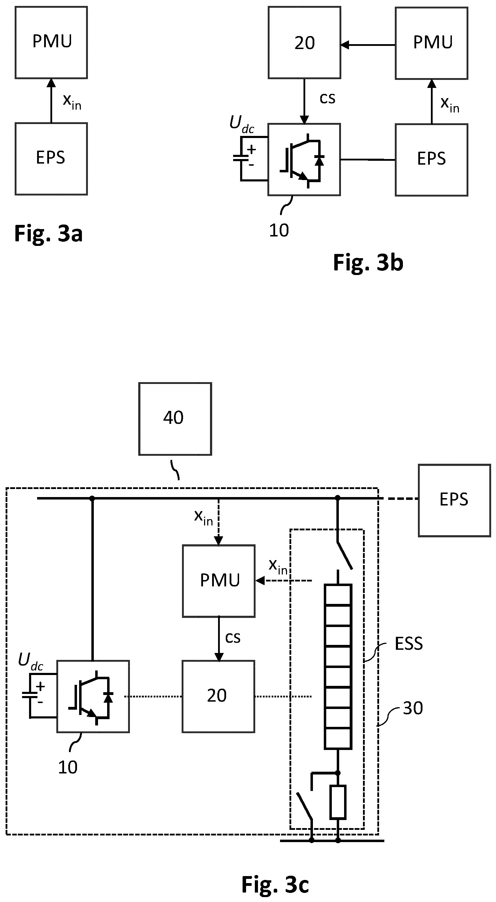

The method according to the present disclosure may be implemented by a phasor measurement unit, PMU, see Figs. 3a-3c. The PMU may be configured to: receive an input signal *x*ᵢₙ(*θ*) corresponding to an electrical parameter of the electrical power system (EPS), wherein the input signal *x*ᵢₙ(*θ*) is based on measurement data from at least one sensor; determine a plurality of dynamic phasors by the method according to any one of the preceding claims, and determine a phasor estimation of the electrical parameter based on the plurality of dynamic phasors.

The electrical parameter of the EPS may correspond to a voltage or current measured at a point-of-common-connection (PCC), where a power supporting system is electrically connected to the EPS. Alternatively, the electrical parameter may correspond to voltage or current at any other location within the EPS. For example, the electrical parameter may be a current or voltage measured at a position along a transmission or distribution power line of the EPS. Current measurements may be provided using a current transformer (CT), while voltage measurements may be provided using a voltage transformer (VT).

The PMU may comprise a processing device configured to execute instructions stored in a data storage unit, which correspond to the phasor estimation method. The processing device may comprise at least one processing unit, such as a processor or microcontroller. The PMU may be configured to communicatively connect to a remote computing device, such as a server, for executing portions (or all of) of the phasor estimation method remotely, thereby offloading computational tasks and enhancing processing capabilities. In such a case, the PMU may serve as a data collection unit for collecting the input signal and providing a corresponding phasor estimation via the phasor estimation method of the present disclosure according to any of its embodiments.

The data storage unit may be configured to log phasor estimations, frequency variations, and/or other relevant measurement data over time. This stored data may be retrieved for post-event analysis, trend detection, and system diagnostics. This may advantageously facilitate: improving grid management; improve, preferably optimize, performance; and/or troubleshooting operational issues.

The PMU may comprise a signal processing unit configured to process and/or sample the input signal. Specifically, the signal processing unit may comprise at least one of: an amplifier, a filter, and an analogue-to-digital converters (ADC). This may advantageously facilitate accurate signal acquisition and/or preparation for subsequent phasor estimation. Further, this may advantageously facilitate that the input signals are appropriately conditioned and/or digitized for reliable phasor estimation.

The PMU may comprise a time synchronization module. The time synchronization module may be configured to synchronize the phasor estimation with an external time reference, such as a Global Positioning System (GPS) signal. This synchronization advantageously facilitates correlating the phasor estimation with performance information across the EPS. It also facilitates the synchronization of phasor estimations across multiple PMUs in a network, providing coordinated measurements from various locations within the EPS.

The PMU may comprise a fault detection module designed to identify anomalies in the received input signals and/or during the processing stages. The fault detection module may be configured to generate an alert signal if abnormal conditions are detected, such as signal distortion, synchronization errors, or loss of input data, thereby enabling timely corrective actions.

The PMU may comprise a communication module configured to transmit the estimated phasor data to an external system, such as a monitoring system or a control device. Examples of such monitoring systems include supervisory control and data acquisition (SCADA) systems and wide-area monitoring systems (WAMS). The communication module may be configured to support a variety of data transmission protocols, such as IEEE C37.118, IEC 61850, or proprietary communication protocols. This may advantageously facilitate seamless interoperability with existing power system monitoring and control networks.

The PMU may be designed to operate effectively across different electrical power system environments, including transmission networks, distribution systems, and microgrids. Furthermore, the PMU may be configured to dynamically adjust processing parameters based on operating conditions of the EPS, thereby improving, preferably optimizing, measurement accuracy and performance across diverse environments.

In certain embodiments, a plurality of PMUs may be utilized for providing phasor estimations of different electrical parameters of the EPS. Each PMU may be configured to receive different input signals corresponding to different electrical parameters of the EPS. This network of PMUs enables comprehensive monitoring and analysis of the EPS, providing a holistic view of its operation and improving system-wide decision-making. The PMUs may be part of a phasor measurement system comprising a plurality of PMUs.

The PMU implementing the method according to the present disclosure may be configured to cooperate with a monitoring system. The PMU, or a plurality of PMUs, may be communicatively connected to a monitoring system, such as a SCADA (Supervisory Control and Data Acquisition) system. Each PMU may be configured to transmit phasor estimations, and optionally other relevant measurements, to the monitoring system. The monitoring system may be configured to use this data to monitor system performance, detect faults, and/or support decision-making for EPS management and control. The integration of at least one PMU with a monitoring system facilitates efficient operation of the EPS and may enhance its reliability and/or stability.

The monitoring system may comprise at least one of a data acquisition device, a processing device, a data storage module, a communication interface, a display device, and a control interface. The data storage module may be configured to store instructions corresponding to a monitoring method. The processing device, which may comprise at least one processor or microcontroller, may be configured to execute the instructions stored in the data storage module. The data acquisition device may communicatively connect to at least one PMU to receive phasor estimations, while the display device may visualize e.g., the phasor estimation, the original input signal, a recreated signal thereof, and/or related information. This allows a user to monitor the status of the EPS and make informed decisions. The user may also control the monitoring method via the control interface.

The PMU implementing the method according to the present disclosure may be configured to cooperate with a control device for controlling power supporting system electrically connected to the EPS. The power supporting system may comprise a converter and/or an energy storage system.

The control device 20 may be configured to: receive at least one phasor estimation from a respective at least one PMU, each phasor estimation corresponding to an electrical parameter of an electrical power system; determine a control signal cs for power supporting system electrically connected to the electrical power system EPS, wherein the control signal cs is based at least on the at least one phasor estimation, and provide the control signal cs to the power supporting system. The power supporting system may comprise a converter 10 and/or an energy storage system ESS.

In particular, the control device may be configured to: determine a power quality compensation based at least on the at least one phasor estimation, wherein the power quality compensation is representative of a current between the power converter 10 and the electrical power system EPS required to suppress a harmonic distortion in the electrical power system EPS, wherein the control signal cs is further based at least on the power quality compensation.

The control device 20 may comprise a communication interface. The communication interface may be configured to receive at least one phasor estimation from a respective PMU. The communication interface may advantageously facilitate establishing a reliable data exchange between the PMU(s) and the control device, enabling the transmission of real-time phasor information corresponding to electrical parameters, such as voltage, current, and frequency, of the EPS. The interface may support various protocols, such as IEEE C37.118, IEC 61850, or proprietary systems, facilitating seamless communication across devices in the EPS.

The control device may comprise a processing device configured to execute instructions stored in a data storage module, which correspond to a control method of controlling a power supporting system based on at least one phasor estimation. The processing device may comprise at least one processing unit, such as a processor or microcontroller. The control device may be configured to communicatively connect to a remote computing device, such as a monitoring system, for receiving additional information to consider when controlling the power supporting system. The data storage module may be configured to store instructions pertaining to a plurality of control methods. The control device may be configured to control the power supporting system according to one of the control methods based on a condition derived from at least one phasor estimation.

The control device may comprise a power quality compensation module. The power quality compensation module may be configured to use at least one phasor estimation for assessing and mitigating issues such as harmonic distortion, voltage sags, or flicker within the electrical power system. Based on the at least one phasor estimation, the power quality compensation module may be configured to determine a required power quality compensation for the power supporting system to suppress harmonic distortions or correct power quality imbalances. The power quality compensation can be in the form of adjusted currents or voltage levels that the power supporting system injects or absorbs to smooth out the power supply.

As indicated by Fig. 3c, the converter 10 or the energy storage system ESS may be comprised in a power supporting system 30. The power supporting system 30 may comprise: at least one converter 10 (such as a power converter) and/or at least one energy storage system ESS configured to electrically connect to an electrical power system via a point of common connection, PCC, and at least one control device 20 for controlling the converter 10 and/or the ESS based on phasor estimation of at least one electrical parameter of the EPS obtained via a respective PMU. A monitoring system 40 as described in the present disclosure may be communicatively connected to the power supporting system 30, the control device 20, and/or at least one PMU 10 (in Fig. 3c only one PMU is illustrated for simplicity). While Figs. 3b-3c schematically illustrate a power converter, the present disclosure is not as such limited to power converters.

The (power) converter 10 may be responsible for converting and regulating energy between different forms (e.g., AC to DC or vice versa), thereby facilitating that power is injected into or absorbed from the EPS as needed. The converter may also be used to control voltage and current, helping to maintain power quality. The converter may contribute to control of active power and/or reactive power in the EPS. The energy storage system, ESS, may be responsible for storing excess energy for later use, absorbing power during low demand and discharging during high demand to stabilize the EPS. The ESS may contribute to control of active power in the EPS (and optionally reactive power if equipped with appropriate power electronics and control mechanisms).

The electrical power system EPS may comprise at least one of: a Flexible AC Transmission System, FACTS; a Photovoltaic, PV, system; an electric vehicle, EV, system, and an electrical power network, EPN.

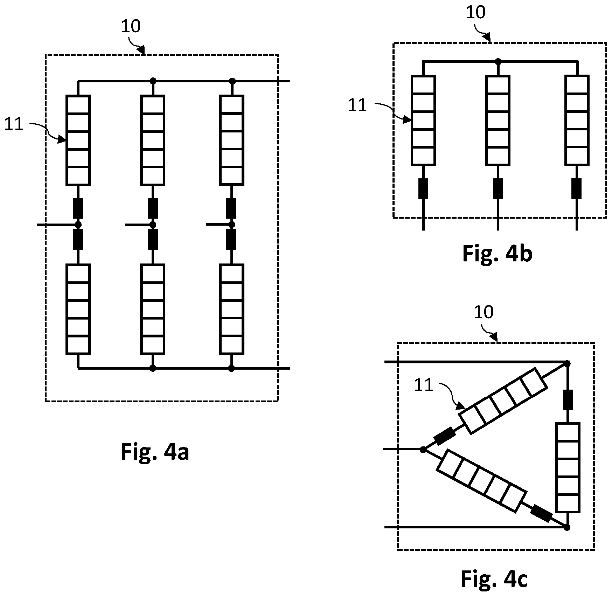

The (power) converter may be a voltage source converter. Figs. 4a-4c schematically illustrate a voltage source converter configured to provide power support in terms of active power and/or reactive power, frequency, voltage, current, etc. as needed. The VSC 10 may be adapted as a monolithic VSC or as a multi-level converter, MMC, based VSC (see Figs. 4a-4c). A monolithic VSC may refer to a VSC implementing a single integrated unit with a centralized design with a few large semiconductor devices (e.g., IGBTs or MOSFETs) to handle high voltages and currents. A MMC-based VSC may refer to a VSC that implements a modular architecture, where the VSC is composed of multiple submodules arranged in series in each phase leg. The MMC-based VSC 10 may be designed as a YY-MMC VSC (see Fig. 4a), a Y-connected chain-link VSC (see Fig. 4b), or a D-connected chain-link VSC (see Fig. 4c).

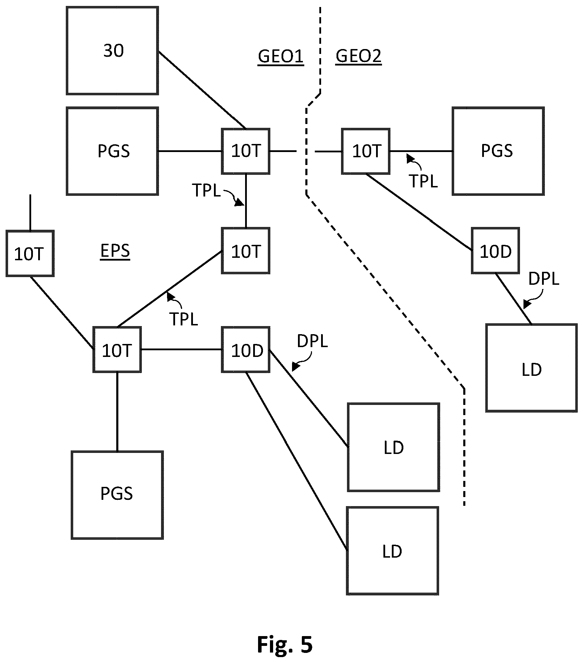

In Fig. 5, the electrical power network EPN is schematically illustrated to comprise one power supporting system 30 electrically connected to a transmission substation 10T. Depending on design and/or control strategy, the power supporting system 30 may provide active power (real power) support and/or reactive power support.

As a non-limiting example, the power supporting system 30 may be configured to provide active power support by storing excess electricity during low demand and supply power during high demand. As a non-limiting example, the power supporting system 30 may be configured to provide active power support by supplying or absorbing power to maintain an operation frequency of the electrical power system (such as an electrical power network) within operational limits relative a target operation frequency (e.g., 50 Hz in Europe or 60 Hz in USA). In addition, as further non-limiting examples, the power supporting system 30 may be configured to provide active power support by implementing any one of black start capability or renewable energy power balancing. As a non-limiting example, the power supporting system 30 may be configured to provide reactive power support by injecting or absorbing reactive power to stabilize voltage levels in transmission system and/or distribution system. As a non-limiting example, the power supporting system 30 may be configured to provide reactive power support by supplying or absorbing reactive power to improve power factor.

The electrical power system of the present disclosure may be configured to be electrically connected to, or comprise, at least one power supporting system 30. The at least one power supporting system 30 may be one power supporting system or a plurality of power supporting systems. The at least one power supporting system may be configured to store electrical power for later use. The at least one power supporting system 30 may be configured to supply electrical energy to the electrical power system EPS in response to a demand variation. Each power supporting system 30 may comprise at least one energy storage unit configured to store electrical energy.

The at least one energy storage unit may be any one of a battery, a super-battery, a capacitor, a super-capacitor, or a flywheel.

The electrical power system EPS may comprise at least one transmission system and/or at least one distribution system configured to electrically connect to at least one substation 10T, 10D. The at least one transmission system and/or the at least one distribution system comprises at least one power line TPL, DPL.

The at least one transmission system may be configured to transmit electrical power from at least one power generation system PGS and/or at least one power supporting system 30 to at least one substation via at least one power line. The transmission system may be configured to electrically connect a plurality of substations using a plurality of power lines to form a network of interconnected substations. Each substation may be configured to receive electrical power from at least one preceding substation via at least one incoming power line and/or supply electrical power to at least one subsequent substation via at least one outgoing power line.

The at least one transmission system may be configured for single-phase or three-phase power transmission. That is, the number of power lines anywhere in the transmission system may correspond to single-phase or three-phase power transmission. However, the present disclosure is not limited to single-phase or three-phase power transmission, but any number of phase power transmission may be implemented.

The at least one transmission system may be configured to operate at high voltage, HV, to reduce transmission losses.

The at least one transmission power line may be adapted for high voltage (HV), specifically high voltage alternating current (HVAC) or high voltage direct current (HVDC).

The at least one transmission power line may be an overhead power line or an underground power line.

Any one power line of the at least one power line of the transmission system may be adapted for HV, specifically HVAC or HVDC.

The at least one distribution system may be configured to distribute electrical power to at least one load LD via at least one power line DPL. The distribution system may be configured to operate at lower voltage levels suitable for end-use applications. The distribution system may be electrically connected to at least one distribution substation 10D configured to step down the voltage of electrical power received from the transmission system to a level suitable for distribution to loads. The at least one load LD may comprise industrial loads, commercial loads, residential loads, or combinations thereof.

The distribution system may be configured for single-phase or three-phase power distribution. That is, the number of power lines anywhere in the distribution system may correspond to single-phase or three-phase power distributed. However, the present disclosure is not limited to single-phase or three-phase power distribution, but any number of phase power distribution may be implemented.

The at least one power line of the distribution system may be adapted for medium voltage, MV, alternating current, MVAC, or low voltage, LV, alternating current, LVAC.

The at least one power line of the distribution system may be adapted for medium voltage direct current, MVDC, or low voltage alternating current, LVAC.

The at least one power line of the distribution system may be an overhead power line or an underground power line.

Any one power line of the distribution system may be formed from materials such as copper or aluminium, selected for their electrical conductivity and durability. The at least one power line of the distribution system may be configured as an overhead power line supported by poles and insulators, or as an underground power line, typically insulated with materials like cross-linked polyethylene (XLPE) or ethylene propylene rubber (EPR) for electrical insulation and protection against environmental factors. The at least one power line of the distribution system may be designed to handle the specific voltage levels associated with MVAC, MVDC, LVAC, or LVDC, with appropriate voltage ratings and insulation to ensure safe and efficient power distribution.

Fig. 5 schematically illustrates the electrical power network EPN to be electrically connected to a plurality of loads LD. Here, a load may refer to any device, system, or facility that consumes electrical power. Loads can vary in size, type, and electrical characteristics, depending on their application. Loads may be residential loads (household appliances, lighting, HVAC systems, and personal electronic devices), commercial load (office buildings, hospitals, etc.), industrial load (factories, manufacturing plants etc.) or transportation load (electric trains, trams, metro systems, and electric vehicle, EV, charging stations). The electrical power network EPN may comprise at least one power supporting system such as a voltage source converter. The power supporting system may alternatively be an energy storage system ESS.

The at least one substation of the electrical power network may be configured to support bidirectional power flow, allowing power to be transmitted in either direction as needed to meet system requirements or operational conditions.

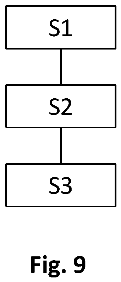

Fig. 9 shows a flow chart of the method according to the present disclosure. The method comprises: estimating a plurality of dynamic phasors *x̂*_{in,*k*}(*θ*) of a single- or multi-phase input signal *x*ᵢₙ(*θ*), corresponding to an electrical parameter of an electrical power system (EPS), which input signal *x*ᵢₙ(*θ*) is at least a quasi-periodic signal generally having a fundamental frequency *ω*, which input signal *x*ᵢₙ(*θ*) is expressible by a Fourier series of the form ${x}_{in} \left(θ\right) = {\sum }_{k = - ∞}^{∞} {\hat{x}}_{in , k} \left(θ\right) {e}^{j kθ}$
wherein *k* is the harmonic order, $k ∈ ℤ$; *x̂*_{in,*k*}(*θ*) is the *k*:th dynamic phasor; e^{j*kθ*} is a basis function for the *k*:th dynamic phasor; and *θ* is a phase angle *θ* = *ωt*, wherein t is time,
wherein said step of estimating said plurality of dynamic phasors *x̂*_{in,*k*}(*θ*) comprises:
   based on information at least indicative of a highest harmonic order of non-negligible dynamic phasors of the input signal *x*ᵢₙ(*θ*); selecting S1 a finite harmonic order *k*ₘₐₓ equal to or greater than said highest harmonic order of non-negligible dynamic phasors of the input signal *x*ᵢₙ(*θ*),
   providing S2 a set of matrix representations (**x̂, K, d, ŷ, G, I, Γ**) based on said input signal *x*ᵢₙ(*θ*) and/or said finite harmonic order *k*ₘₐₓ, and
   computing S3 a plurality of matrix operations applied to said set of matrix representations (**x̂**, **K, d, ŷ, G, I, Γ**) to provide a corresponding plurality of dynamic phasor estimates *x̂ₖ*(*θ*) (*k* ∈ {-*k*ₘₐₓ, ... , *k*ₘₐₓ}) to said plurality of dynamic phasors *x̂*_{in,*k*}(*θ*), wherein the plurality of matrix operations represents at least a first step of extracting signals *ŷₖ*(*θ*) (*k* ∈ {-*k*ₘₐₓ, ... , *k*ₘₐₓ}) from the input signal *x*ᵢₙ(*θ*) by application of a plurality of low-pass filters, and a second step of applying harmonic cancellation on the signal components *y**ₖ***(*θ*) *=* e*^{jkθ}ŷₖ*(*θ*),
   wherein said phase angle *θ* is controlled via a phase locked loop, PLL, which PLL receives as input at least one component of the plurality of dynamic phasor estimates *x̂ₖ*(*θ*)*.*

While the foregoing is directed to embodiments of the disclosure, other and further embodiments may be devised without parting from the inventive concept discussed herein. The scope of the invention is however determined by the claims.

## Claims

1. A computer-implemented method comprising:
estimating a plurality of dynamic phasors *x̂*_{in,*k*}(*θ*) of a single- or multi-phase input signal *x*ᵢₙ(*θ*), corresponding to an electrical parameter of an electrical power system (EPS), which input signal *x*ᵢₙ(*θ*) is at least a quasi-periodic signal generally having a fundamental frequency *ω*, which input signal *x*ᵢₙ(*θ*) is expressible by a Fourier series of the form ${x}_{in} \left(θ\right) = {\sum }_{k = - ∞}^{∞} {\hat{x}}_{in , k} \left(θ\right) {e}^{j kθ}$ wherein *k* is the harmonic order, $k ∈ ℤ$; *x̂*_{in,*k*}(*θ*) is the *k*:th dynamic phasor; e^{j*kθ*} is a basis function for the *k*:th dynamic phasor; and *θ* is a phase angle *θ* = *ωt*, wherein *t* is time,
wherein
said step of estimating said plurality of dynamic phasors *x̂*_{in*,k*}(*θ*) comprises:
based on information at least indicative of a highest harmonic order of non-negligible dynamic phasors of the input signal *x*ᵢₙ(*θ*); selecting (S1) a finite harmonic order *k*ₘₐₓ equal to or greater than said highest harmonic order of non-negligible dynamic phasors of the input signal *x*ᵢₙ(*θ*),
providing (S2) a set of matrix representations (**x̂**, **K, d, ŷ, G, I, Γ**) based on said input signal *x*ᵢₙ(*θ*) and/or said finite harmonic order *k*ₘₐₓ,
and
computing (S3) a plurality of matrix operations applied to said set of matrix representations (**x̂, K, d, ŷ, G, I, Γ**) to provide a corresponding plurality of dynamic phasor estimates *x̂ₖ*(*θ*) (*k* ∈ {-*k*ₘₐₓ, ... , *k*ₘₐₓ}) to said plurality of dynamic phasors *x̂*_{in,*k*}(*θ*), wherein the plurality of matrix operations represents at least a first step of extracting signals *ŷₖ*(*θ*) (*k* ∈ {-*k*ₘₐₓ, ... , *k*ₘₐₓ}) from the input signal *x*ᵢₙ(*θ*) by application of a plurality of low-pass filters, and a second step of applying harmonic cancellation on the signal components *yₖ*(*θ*) *= e^{jkθ}ŷₖ*(*θ*),
wherein said phase angle *θ* is controlled via a phase locked loop, PLL, which PLL receives as input at least one component of the plurality of dynamic phasor estimates *x̂ₖ*(*θ*)*.*

2. The method according to claim 1, wherein said providing a set of matrix representations (**x̂**, **K, d, ŷ, G**, **I, Γ**) based on said input signal *x*ᵢₙ(*θ*) and said finite harmonic order *k*ₘₐₓ comprises:
providing a first matrix representation (**x̂**) which is a vector of length [2*k*ₘₐₓ + 1] defined as $\hat{x} : = \left(\begin{matrix}{\hat{x}}_{- {k}_{max}} \left(θ\right) \\ ⋮ \\ {\hat{x}}_{{k}_{max}} \left(θ\right)\end{matrix}\right)$
providing a second matrix representation (**K**) which is a square matrix of size [2*k*ₘₐₓ + 1 ] × [2*k*ₘₐₓ + 1] defined as $K : = \left(\begin{matrix}- {k}_{max} & & 0 \\ & ⋱ & \\ 0 & & {k}_{max}\end{matrix}\right)$
providing a third matrix representation (**d**) which is a diagonal vector of length [2*k*ₘₐₓ + 1] defined as $d : = \left(\begin{matrix}1 \\ ⋮ \\ 1\end{matrix}\right) .$

3. The method according to claim 2, wherein said providing a set of matrix representations (**x̂**, **K, d, ŷ, G**, **I, Γ**) based on said input signal *x*ᵢₙ(*θ*) and said finite harmonic order *k*ₘₐₓ comprises:
providing a fourth matrix representation (**ŷ**) which is a vector of length [2*k*ₘₐₓ + 1] defined as $\hat{y} \left(θ\right) : = \left(\begin{matrix}{\hat{y}}_{- {k}_{max}} \left(θ\right) \\ ⋮ \\ {\hat{y}}_{{k}_{max}} \left(θ\right)\end{matrix}\right)$
wherein the elements *ŷₖ* are the elements which solve the differential equation corresponding to a low-pass filtering step $\frac{d}{d θ} {\hat{y}}_{k} \left(θ\right) = {γ}_{k} \left({x}_{in}\left(θ\right){e}^{- j kθ}-{\hat{y}}_{k}\left(θ\right)\right)$
Wherein the *γₖ* are predetermined, fixed relaxation rates;
providing a fifth matrix representation (**G**) which is a Hermitian matrix of size [2*k*ₘₐₓ + 1] × [2*k*ₘₐₓ + 1] defined as ${G}_{l , k} : = \frac{1}{1 + \frac{j}{{γ}_{k}} \left(k-l\right)}$ for all *k*, *l* ∈ {-kₘₐₓ, ... , kₘₐₓ},
providing a sixth matrix representation (**I**) which is a unit matrix having size [2*k*ₘₐₓ + 1] × [2*k*ₘₐₓ + 1] $I : = \left(\begin{matrix}1 & & 0 \\ & ⋱ & \\ 0 & & 1\end{matrix}\right) ,$
and a seventh matrix representation (**Γ**) which is a diagonal matrix of size [2*k*ₘₐₓ + 1] × [2*k*ₘₐₓ + 1] with diagonal elements *γₖ* : $Γ : = \left(\begin{matrix}{γ}_{- {k}_{max}} & & 0 \\ & ⋱ & \\ 0 & & {γ}_{{k}_{max}}\end{matrix}\right) .$

4. The method according to claim 3, wherein said providing a set of matrix representations (**x̂**, **K, d, ŷ, G, I, Γ**) based on said input signal *x*ᵢₙ(*θ*) and said finite harmonic order *k*ₘₐₓ comprises:
providing an eight matrix representation (**x**) which is a vector of length [2*k*ₘₐₓ + 1] defined as $x \left(θ\right) = {e}^{j θ K} \hat{x} \left(θ\right)$
providing a ninth matrix representation (**y**) which is a vector of length [2*k*ₘₐₓ + 1] defined as $y \left(θ\right) = {e}^{j θ K} \hat{y} \left(θ\right) .$

5. The method according to claim 4, wherein said computing a plurality of matrix operations applied to said set of matrix representations comprises at least:
a first matrix operation corresponding to a low-pass filtering step defined as $\left(\frac{d}{d θ}+Γ-jK\right) y = Γd {x}_{in} \left(θ\right)$
a second matrix operation defined as $x \left(θ\right) = {G}^{- 1} y \left(θ\right)$
a third matrix operation defined as $\hat{x} \left(θ\right) = {e}^{- j θ K} x \left(θ\right) .$

6. The method according to any one of the preceding claims, wherein the maximum order *k*ₘₐₓ of non-negligible dynamic phasors of the input signal *x*ᵢₙ(*θ*) can for instance be determined by:
setting an amplitude threshold for the harmonic components of typical (for the targeted application) input signal, and
determining, as the non-negligible dynamic phasors, the dynamic phasors of the input signal *x*ᵢₙ(*θ*) having a magnitude exceeding the amplitude threshold.

7. The method according to any one of the preceding claims, wherein all *γₖ* are chosen to be equal, i.e., **Γ** = **γI** with some fixed relaxation rate *γ* > 0.

8. The method according to any one of the preceding claims, wherein the method is implemented to provide the plurality of dynamic phasors in continuous time domain.

9. The method according to any one of claims 1-7, wherein the method is implemented to provide the plurality of dynamic phasors in discrete time domain.

10. A phasor measurement unit (PMU), configured to:
receive an input signal *x*ᵢₙ(*θ*) corresponding to an electrical parameter of the electrical power system (EPS), wherein the input signal *x*ᵢₙ(*θ*) is based on measurement data from at least one sensor;
determine a plurality of dynamic phasors by the method according to any one of the preceding claims, and
determine a phasor estimation of the electrical parameter based on the plurality of dynamic phasors.

11. A monitoring system comprising:
at least one phasor measurement unit (PMU) according to claim 10, wherein the monitoring system is configured to:
receive at least one input signal *x*ᵢₙ(*θ*) corresponding to a respective at least one electrical parameter of the electrical power system (EPS), each input signal *x*ᵢₙ(*θ*) being based at least on measurement data from at least one sensor, and
determine, by the at least one phasor measurement unit (PMU), at least one phasor estimation of the respective electrical parameter corresponding to the at least one input signal *x*ᵢₙ(*θ*); and
monitoring the at least one phasor estimation to detect whenever the at least one phasor estimation deviates from a predetermined interval.

12. A control device (20) configured to:
receive at least one phasor estimation from a respective at least one phasor measurement unit (PMU) according to claim 10, each phasor estimation corresponding to an electrical parameter of an electrical power system;
determine a control signal (cs) for a power converter (10) or an energy storage system (ESS) electrically connected to the electrical power system (EPS), wherein the control signal (cs) is based at least on the at least one phasor estimation, and
provide the control signal (cs) to the power converter (10) or the energy storage system (ESS).

13. The control device according to claim 12, configured to:
determine a power quality compensation based at least on the at least one phasor estimation, wherein the power quality compensation is representative of a current between the power converter (10) and the electrical power system (EPS) required to suppress a harmonic distortion in the electrical power system (EPS),
wherein the control signal (cs) is further based at least on the power quality compensation.

14. A power supporting system comprising:
at least one power converter (10) and/or at least one energy storage system (ESS) configured to electrically connect to an electrical power system via a point of common connection, PCC, and
at least one control device (20) according to any one of claims 12-13 configured to control the at least one power converter (10) and/or the at least one energy storage system (ESS).

15. The power supporting system according to claim 14, wherein the electrical power system (EPS) comprises at least one of:
a Flexible AC Transmission System, FACTS;
a Photovoltaic, PV, system;
an electric vehicle, EV, system, and
an electrical power network, EPN.
